# EUROPEAN PATENT SPECIFICATION

(11) **EP 2 800 148 B1**
(45) Date of publication and mention of the grant of the patent: **04.04.2018**
(21) Application number: 12861108.4
(22) Date of filing: 27.12.2012
(51) Int. Cl.: H01L 31/042, B32B 27/00

(54) **PROTECTIVE SHEET**
SCHUTZFOLIE
FEUILLE PROTECTRICE

(30) Priority: 28.12.2011 JP 2011290036; 27.03.2012 JP 2012071862; 13.12.2012 JP 2012272837; 13.12.2012 JP 2012272839
(43) Date of publication of application: 05.11.2014
(73) Proprietor: Mitsubishi Chemical Corporation, Tokyo 100-8251 (JP)
(72) Inventor: NINOMIYA, Naoya, Ushiku-shi Ibaraki 300-1201 (JP); AYA, Tetsuya, Ushiku-shi Ibaraki 300-1201 (JP); AKAIKE, Osamu, Ushiku-shi Ibaraki 300-1201 (JP); KUDOU, Hirofumi, Ushiku-shi Ibaraki 300-1201 (JP); MITSUKURA, Yumi, Ushiku-shi Ibaraki 300-1201 (JP)
(74) Representative: Ter Meer Steinmeister & Partner
(86) International application number: PCT/JP2012/083998
(87) International publication number: WO 2013/100109

(56) References cited:
- WO-A1-2010/150692
- JP-A- H0 685 300
- JP-A- H07 142 756
- JP-A- 2009 188 072
- US-A1- 2002 129 848

## Description

### Technical Field

The present invention relates to a protective sheet formed from a laminate. More specifically, the present invention relates to a protective sheet used for a solar cell.

### Background Art

In recent years, solar cells directly converting sunlight into electric energy has been drawing attention and developed from the aspect of efficient use of resources, by prevention of environmental pollution, and the like. The solar cell is formed by sealing a solar cell between a front protective sheet (hereinafter sometimes referred to as "front sheet") and a back protective sheet (hereinafter sometimes referred to as "back sheet") with a sealing film such as an ethylene-vinyl acetate copolymer film, a polyethylene film, or a polypropylene film.

A protective sheet as the front protective sheet or the back protective sheet of a solar cell is required to have excellent durability to ultraviolet rays and to produce excellent effect in suppressing curl generation after experiences a high temperature environment. Additionally, a protective sheet is extremely significantly required to have excellent moisture resistance to prevent the internal lead and the electrode from rusting caused by the penetration of moisture and the like. Furthermore, an excellent protective sheet with slightly decrease in the moisture resistance under the long-term use and the high temperature condition is desired to be developed.

Patent document 1 proposes that laminating a layer formed of an aromatic vinyl resin (II) having a lower glass transition temperature than a thermoplastic resin (I) having a specific glass transition temperature to the base material layer formed of the thermoplastic resin (I) can provide excellent heat resistance, weather-resistant, hydrolysis resistance, and flexibility, and suppress curl generation.

Patent document 2 proposes that a protective sheet for a solar cell module is formed through the step A of forming a base material film and a coating film in which an ethylene-vinyl acetate copolymer is uncured on at least one side of the base material film and the step B of curing the uncured coating film so as to suppress distortion of the solar cell module.

### Citation List

### Patent Literature

Patent document 1: JP 2009-51207 A
Patent document 2: JP 2010-232233 A
JP-A-2009/188072 and US-A-2002/129848 both disclose laminated sheet for solar cells.

### Summary of Invention

### Technical Problem

The technologies disclosed in Patent documents 1 and 2 pay attention to the material, the properties, the production process, of each layer to suppress curl generation and the like but do not pay attention to the shape, the size, of each layer. Moreover, the technologies produce insufficient effect in suppressing curl generation.

An objective of the present invention is to provide a protective sheet such as a solar cell protective sheet suppressing curl generation and having excellent appearance and a solar cell module formed by using this protective sheet.

Another objective of the present invention is to provide a protective sheet capable of suppressing delamination of the end faces of a laminate.

### Solution to Problem

As a result of their extensive study, the inventors found that a protective sheet including a weather-resistant film A, an adhesive layer 1, a film B, an adhesive layer 2, a film C in the stated order, the film C having a thickness of 60 µm or more, in which the widths of the film B and the film C are less than that of the weather-resistant film A, the width of the film C is more than that of the film B, prevents curl generation in the obtained protective sheet so as to achieve the present invention.

According to the present invention,
[1] A protective sheet includes a weather-resistant film A, an adhesive layer 1, a film B, an adhesive layer 2, a film C in the stated order, the film C having a thickness of 60 µm or more, in which the width W_{A} of the weather-resistant film, the width W_{B} of the film B, and the width W_{C} of the film C have a relationship of W_{A}>W_{C}>W_{B}.
[2] In the protective sheet according to [1], the ratio (W_{B}/W_{C}) of the width W_{B} to the width W_{C} is 0.65 or more and less than 1.0, and the difference (W_{C}-W_{B}) between the width W_{C} and the width W_{B} is 32 mm or less.
[3] In the protective sheet according to [1] or [2], the ratio (W_{C}/W_{A}) of the width W_{C} to the width W_{A} is 0.70 or more and less than 1.0, and the difference (W_{A}-W_{C}) between the width W_{A} and the width W_{C} is 80 mm or less.
[4] In the protective sheet according to any one of [1] to [3], the ratio of the thickness of the weather-resistant film A to the thickness of the film C (thickness of weather-resistant film A/thickness of film C) is 0.75 or less.
[5] In the protective sheet according to any one of [1] to [4], the tensile elastic modulus at 23 °C of the film C is 2.0 GPa or more.
[6] In the protective sheet according to any one of [1] to [5], the film B is a moisture-resistant film having a base material and an inorganic layer in the base material on at least one side of the base material and having a moisture vapor permeability of less than 0.1 g/m²/day.
[7] In the protective sheet according to [6], the inorganic layer side of the moisture-resistant film is laminated to the weather-resistant film A.
[8] In the protective sheet according to any one of [1] to [7], the adhesive layer 1 and/or the adhesive layer 2 contains a pressure sensitive adhesive agent.
[9] In the protective sheet according to any one of [1] to [8], the thermal shrinkage rate of the weather-resistant film A is 0.5% or more.
[10] The protective sheet according to any one of [1] to [9], the protective sheet is used in a solar cell protective sheet.
[11] An encapsulating material-integrated protective sheet is formed by further laminating an encapsulating material layer D on the film C side of the protective sheet according to any one of [1] to [10].
[12] In the encapsulating material-integrated protective sheet according to [11], the width W_{D} of the encapsulating material layer is less than the width W_{A} of the weather-resistant film and more than the width W_{C} of the film C.
[13] A roll-shaped article is formed by rolling up the protective sheet according to any one of [1] to [10] or the encapsulating material-integrated protective sheet according to [11] or [12].
[14] A roll-shaped article with a cover sheet is formed by at least partially covering a part at which the weather-resistant film A projects from the surface of the roll-shaped article according to [13] with a cover sheet having a deflection length of 70 mm or less and a load bearing dent of 0.1 or less, in which
   the deflection length is measured in a condition in which
   (1) A sample with a width of 20 mm and a length of 120 mm is collected,
   (2) the sample is placed on and protruded from a platform so that the protuberance from the platform has a length of 100 mm, and then a 5 kg weight is added on the part of the sample on the platform to fix the sample, and
   (3) how much the end of the part of the sample being protruded from the platform hangs down from the platform is measured, and this measured length x (unit: mm) is determined as the deflection length,
   the load bearing dent is measured in a condition in which
   (1) A 100 mm square sample is collected,
   (2) the sample is placed on a glass plate with a thickness of 20 mm, a 0.5 g steel ball with a diameter of 5 mm is added on the central part of the sample, and a 2 kg load is further added on the steel ball, and
   (3) The dent "d" in the sample (unit: µm) is measured, and the ratio "d/t" of the dent "d" to the thickness "t" (unit: µm) of the sample is determined as the load bearing dent.
[15] In the roll-shaped article with a cover sheet according to [14], the conditions (a') and/or (b') are satisfied,
   the condition (a') is deflection length of cover sheet / deflection length of weather-resistant film A ≤ 2, and
   the condition (b') is load bearing dent of cover sheet / load bearing dent of weather-resistant film A ≤ 2.
[16] A method of producing a protective sheet includes the steps of:
   (1) forming a laminate X having an adhesive layer 1 on one side of the film B and an adhesive layer 2 on the other side of the film B,
   (2) slitting both the ends in the width direction of the laminate X to form a laminate X',
   (3) attaching a weather-resistant film A having a width W_{A} being more than the width W_{X'} of the laminate X' to the adhesive layer 1 so that both the ends of the weather-resistant film A project from the respectively corresponding ends of the adhesive layer 1, and
   (4) attaching a film C having a width W_{C} being more than the width W_{X'} of the laminate X' and less than the width W_{A} of the weather-resistant film A to an adhesive layer 2 so that both the ends of the film C project from the respectively corresponding ends of the adhesive layer 2.
[17] In the method of producing a protective sheet according to [16], the laminate X having a release sheet 1 on the adhesive layer 1 and a release sheet 2 on the adhesive layer 2 is produced in the step (1), the release sheet 1 is peeled off after the step (2) before the step (3), and the release sheet 2 is peeled off after the step (2) before the step (4).
[18] In the method of producing a protective sheet according to [17], the step (1) has the steps of:
   (1-1) applying an adhesive layer 1 composition to the release sheet 1 and drying the adhesive layer 1 to form an adhesive layer 1,
   (1-2) applying an adhesive layer 2 composition to the release sheet 2 and drying the adhesive layer 2 to form an adhesive layer 2, and
   (1-3) attaching the film B between the adhesive layer 1 and the adhesive layer 2 to form a laminate X.
[19] A solar cell module is formed by using the protective sheet according to any one of [1] to [10] or the encapsulating material-integrated protective sheet according to [11] or [12] .

### Advantageous Effects of Invention

The present invention can provide a protective sheet such as a solar cell protective sheet, a protective sheet preventing curl generation in a laminated article formed by using the same and having excellent appearance, and a solar cell module formed by using this protective sheet.

The present invention can also provide a protective sheet capable of suppressing delamination of the end faces of a laminate.

### Brief Description of Drawings

FIG. 1 shows a sectional view illustrating an embodiment of the protective sheet of the present invention.
FIG. 2 shows a sectional view illustrating an example of use of the protective sheet of the present invention.
FIG. 3 shows a diagram illustrating the evaluation method of the deflection length.
FIG. 4 shows a diagram illustrating the evaluation method of the load bearing dent.
FIG. 5 shows a diagram illustrating an embodiment of the method of producing the protective sheet of the present invention.
FIG. 6 shows a diagram illustrating an embodiment the step (1) of the method of producing the protective sheet of the present invention.
FIG. 7 shows a sectional view illustrating an example of the protective sheet obtained by a conventional method of producing a protective sheet.

### Description of Embodiments

The present invention will be explained in more detail below.

In a protective sheet composed of a laminate with two or more films, a marked curl may be generated due to the difference among the thermal shrinkage rates of the films, for example, when experiences a high temperature environment. For example, in the solar cell module, a curl is easily generated because the thermal shrinkage rate of the weather-resistant film at the exposed side is different from that of another film layer such a moisture-resistant layer.

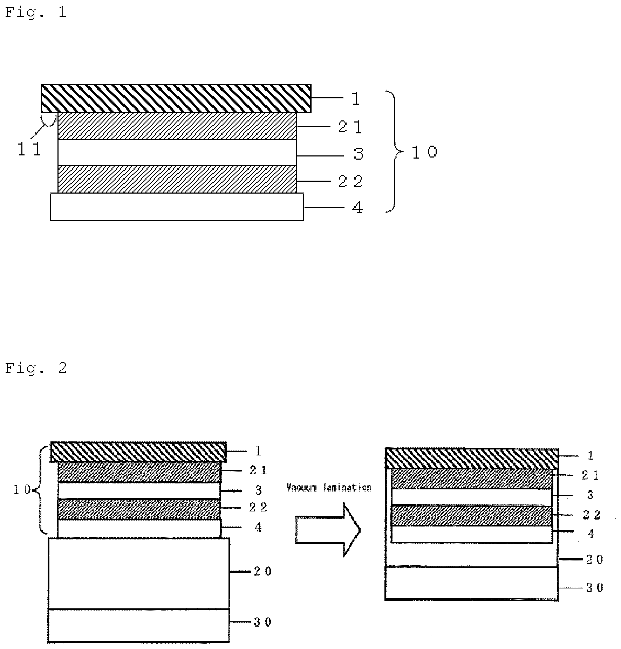

In view of the above-mentioned problems, the inventors found that a protective sheet including a weather-resistant film A, an adhesive layer 1, a film B, an adhesive layer 2, a film C in the stated order, the film C having a thickness of 60 µm or more, in which the widths of the film B and the film C other than the weather-resistant film A are less than that of the weather-resistant film A, the width of the film C is more than that of the film B, suppresses curl generation in the obtained protective sheet so as to achieve excellent appearance. The inventors also found that this structure wrapping an encapsulating material (20) on an electronic device (30) around the end faces of the film B (3) and the film C (4) to prevent delamination in the end faces having smaller width than the weather-resistant film A (1) as shown in FIG. 2. Thus, this structure can achieve an objective of the present invention.

### Protective sheet

As given as an example shown in FIG. 1, a protective sheet (10) includes a weather-resistant film A (1), an adhesive layer 1 (21), a film B (3), an adhesive layer 2 (22), a film C (4) in the stated order, the film C having a thickness of 60 µm or more, in which the width W_{A} of the weather-resistant film, the width W_{B} of the film B, and the width W_{C} of the film C have a relationship of W_{A}>W_{C}>W_{B}. The structural films will be explained below.

### Weather-resistant film A

The protective sheet of the present invention has a weather-resistant film A (hereinafter sometimes merely referred to as "weather-resistant film") having hydrolysis resistance and weather resistance to impart long-term durability.

The weather-resistant film is preferably a fluorine-based resin film in view of the weather resistance. As the fluorine-based resin, for example, polytetrafluoroethylene (PTFE), a tetrafluoroethylene-perfluoroalkyl vinyl ether copolymer (PFA), a tetrafluoroethylene-hexafluoropropylene copolymer (FEP), a tetrafluoroethylene-ethylene copolymer (ETFE), polychlorotrifluoroethylene (PCTFE), polyvinylidene fluoride (PVDF), polyvinyl fluoride (PVF), and the like are preferably used.

From the viewpoint of the long-term durability, tetrafluoroethylene-ethylene copolymer (ETFE) and tetrafluoroethylene-hexafluoropropylene copolymer (FEP) are more preferably used as the above-mentioned fluorine-based resin.

The weather-resistant film is preferably a weather-resistant base material with a low shrinkage, such as polyethylene naphthalate, given that the properties of the weather-resistant film preferably slightly change in vacuum lamination and in the change of temperature and humidity. In particular, a film in which the large shrinkage rate of a poly ethylene terephthalate film or a fluorine-based film is reduced by previous heat treatment is preferable.

Various additives can optionally be added to the weather-resistant film. In a solar cell protective sheet, examples of the additive include an ultraviolet absorber, a weather-resistant stabilizer, an antioxidant, an antistat, and an anti-blocking agent but are not limited thereto.

The thickness of the weather-resistant film in a solar cell protective sheet is generally about 20 to 150 µm. From the viewpoint of the handleability and the cost of the film, the thickness is preferably 20 to 100 µm, more preferably 20 to 60 µm.

In the present invention, the below-mentioned film C can suppress curl generation in the protective sheet even if the weather-resistant film is not previously heat-treated to lower the thermal shrinkage rate. From the viewpoint of further producing the effect in suppressing curl generation in the protective sheet, the thermal shrinkage rate of the weather-resistant film is preferably 0.3 to 5.0%, more preferably 0.5 to 4.0%, further more preferably 1.0 to 3.5%. Moreover, the thermal shrinkage rate in the width direction and the length direction of the film, which falls within this range, produces the significant effect.

The thermal shrinkage rate can be calculated by the expression (L₀-L₁)×100/L₀ in which L₀ represents the length of a sample before heating, L₁ represents the length of a sample after heating at 150 °C for 30 minutes with an oven.

### Film B

The film B is laminated to the above-mentioned weather-resistant film through the adhesive layer 1. For example, the film B having vapor barrier properties and oxygen barrier properties preferably variously used. Specifically, a resin film formed of any of materials, for example, a polyolefin such as a homopolymer or a copolymer of ethylene, propylene, butene, and the like; an amorphous polyolefin such as a cyclic polyolefin; polyesters such as a polyethylene terephthalate (PET) and a polyethylene naphthalate (PEN); polyamides such as nylon 6, nylon 66, nylon 12, and a copolymerized nylon; and an ethylene-vinyl acetate copolymer partial hydrolysate (EVOH), a polyimide, a polyetherimide, a polysulfone, a polyether sulfone, a polyether ether ketone, a polycarbonate, a polyvinyl butyral, a polyarylate, a fluorine resin, an acrylic resin, and a biodegradable resin; and a moisture-resistant film in which an inorganic layer is formed on the base material are used. When the protective sheet of the present invention is used for a solar cell protective sheet, the film B is preferably a moisture-resistant film.

The thickness of the film B is generally about 5 to 100 µm. From the viewpoint of the productivity and the handleability, the thickness is preferably 8 to 50 µm, more preferably 10 to 25 µm.

### Moisture-resistant film

The moisture-resistant film preferably has a base material and an inorganic layer formed on at least one side of the base material. Since a solar cell protective sheet is desired to maintain a high moisture resistance for a long term, the initial moisture resistance should be more than a certain level. Therefore, in the present invention, the above-mentioned moisture-resistant film preferably has a moisture vapor permeability of less than 0.1 g/m²/day, more preferably 0.05 g/m²/day or less, further more preferably 0.03 g/m²/day or less. Moreover, the moisture-resistant film is preferably transparent when the solar cell protective sheet is used as the front sheet used for the sunlight-receiving side.

The base material of the above-mentioned moisture-resistant film is preferably a resin film. Any materials can be used for the base material without any limitation in particular as long as being resins usable for a typical solar cell material.

Specifically, examples of the material of the base material include a polyolefin such as a homopolymer or a copolymer of ethylene, propylene, butene, and the like; an amorphous polyolefin such as a cyclic polyolefin; polyesters such as a polyethylene terephthalate (PET) and a polyethylene naphthalate (PEN); polyamides such as nylon 6, nylon 66, nylon 12, and copolymerized nylon; and an ethylene-vinyl acetate copolymer partial hydrolysate (EVOH), a polyimide, a polyetherimide, a polysulfone, a polyether sulfone, a polyether ether ketone, a polycarbonate, a polyvinyl butyral, a polyarylate, a fluorine resin, an acrylic resin, and a biodegradable resin. Particularly, the material of the base material is preferably a thermoplastic resin. From the viewpoint of the film properties, the cost, and the like, the material of the base material is more preferably a polyester, a polyamide, and a polyolefin. From the viewpoint of the surface smoothness, the film strength, the heat resistance, and the like, the material of the base material is particularly preferably a polyethylene terephthalate (PET) and a polyethylene naphthalate (PEN).

Various additives can optionally be added to the above-mentioned base material. Examples of the additive include an antistat, an ultraviolet absorber, a plasticizer, a lubricant, a filler, a colorant, a weather-resistant stabilizer, an anti-blocking agent, and an antioxidant but are not limited thereto.

Examples of the usable UV absorber include various types such as benzophenone-based, benzotriazole-based, triazine-based, and salicylic acid ester-based types. Thus, various commercially available products are applicable to the UV absorber.

A resin film as the above-mentioned base material is formed by using the above-mentioned raw materials but may be oriented or unoriented. In addition, the resin film may be monolayered or multilayered.

This base material can be produced by a conventionally known method. For example, the unoriented film which is not substantially amorphous and not oriented can be manufactured by melting the raw materials by an extruder, extruding the melted raw materials by a ring die and a T-die, and quenching the extruded raw materials. Moreover, a monolayered film formed of one kind of resin, a multilayered film formed of one kind of resin, a multilayered film formed of many kinds of resins, and the like can be produced by using a multilayer die.

The unoriented film is oriented in the flow (longitudinal axis) direction of the film or the vertical (lateral axis) direction to the flow direction of the film by known methods such as uniaxial orientation, tenter type sequential biaxial extension, tenter type simultaneous biaxial orientation, and tubular simultaneous biaxial orientation to produce a film oriented in the uniaxis or biaxial direction. The oriented rate can be optionally set. The thermal shrinkage rate at 150 °C in at least one of the width direction or the length direction of the film is preferably 0.01 to 5%, more preferably 0.01 to 2%. Particularly, from the viewpoint of the film properties, a coextruded biaxially oriented film in which a biaxially-oriented poly ethylene terephthalate film, a biaxially-oriented polyethylene naphthalate film, a polyethylene terephthalate, and/or a polyethylene naphthalate is coextruded with another resin is preferable.

The thickness of the above-mentioned base material is generally 5 to 100 µm. From the viewpoint of the productivity and the handleability, the thickness is preferably 8 to 50 µm, more preferably 10 to 25 µm.

On the above-mentioned base material, an anchor coat layer is preferably formed to improve the adhesion with the inorganic layer. For the anchor coat layer, a solvent or an aqueous polyester resin; alcoholic hydroxyl group-containing resins such as an isocyanate resin, an urethane resin, an acrylic resin, a modified vinyl resin, and a vinyl alcohol resin; and a vinyl butyral resin, a nitrocellulose resin, an oxazoline group-containing resin, a carbodiimide group-containing resin, a melamine group-containing resin, an epoxy group-containing resin, a modified styrene resin, a modified silicone resin, and the like can be used alone or in combination of two or more. In the anchor coat layer, alkyl titanate, a silane-based coupling agent, a titanium-based coupling agent, a UV absorber, a weather-resistant stabilizer, a lubricant, a blocking inhibitor, or an antioxidant, can be optionally added. As the ultraviolet absorber, the weather-resistant stabilizer, and the antioxidant, the same types as those used for the above-mentioned base material or the polymer types in which a weather-resistant stabilizer and/or an ultraviolet absorber are copolymerized with the above-mentioned resin can be used.

From the viewpoint of improving the adhesion with the inorganic layer, the thickness of the anchor coat layer is preferably 10 to 200 nm, more preferably 10 to 100 nm. Known coating methods are appropriately adopted as the method of forming the anchor coat layer. For example, any method such as a coating method employing a reverse roll coater, a gravure coater, a rod coater, an air doctor coater, or a spray can be used. The base material may be immersed in a liquid resin. After the coating, the solvent can be evaporated by employing a known drying method such as hot-air drying at a temperature of 80 to 200°C, heat drying such as heat roll drying, or infrared drying. In addition, a crosslinking treatment by electron beam irradiation can be performed for improving water resistance and durability. The anchor coat layer may be formed in the middle of the production line of the base material (in-line) or after the base material is produced (off-line).

An inorganic substance forming the inorganic layer is exemplified by silicon, aluminum, magnesium, zinc, tin, nickel, or titanium; or an oxide, carbide, or nitride thereof, or a mixture thereof. Among these, silicon oxide, silicon nitride, silicon oxynitride, aluminum oxide, and diamond-like carbon are preferable because of their transparency. In particular, silicon oxide, silicon nitride, silicon oxynitride, and aluminum oxide are preferable because they can stably maintain high gas barrier properties.

Any one of the methods such as a vapor deposition method and a coating method can be employed as a method of forming the inorganic layer. Among these, the vapor deposition method is preferable because a uniform thin layer having high gas barrier properties is obtained. The vapor deposition method includes physical vapor deposition (PVD) and chemical vapor deposition (CVD). Examples of the physical vapor deposition method include vacuum deposition, ion plating, and sputtering. Examples of the chemical vapor deposition method include plasma CVD involving utilizing plasma and a catalytic chemical vapor deposition method (Cat-CVD) involving subjecting a material gas to catalytic pyrolysis with a heating catalyst body.

The inorganic layer may be monolayered or multilayered. Each layer of the multilayer inorganic layer may be formed by using the same deposition method or a different deposition method. In any of these cases, the deposition is preferably sequentially conducted under reduced pressure from the viewpoint of efficiently improving the moisture resistance and the productivity.

Particularly, the multilayer structure preferably contains an inorganic layer formed by vacuum deposition, an inorganic layer formed by chemical vapor deposition, and an inorganic layer formed by vacuum deposition in the stated order.

Each layer of the multilayer inorganic layer may be formed of the same inorganic substance or a different inorganic substance.

The thickness of the above-mentioned inorganic layer is preferably 10 to 1000 nm, more preferably 20 to 800 nm, further more preferably 20 to 600 nm from the viewpoint of exhibiting stable moisture resistance.

### Film C

The film C is to be attached to the above-mentioned film B through the adhesive layer 2. As the film C, a resin film with a thickness of 60 µm or more is used. The film C with an elastic modulus of at 23 °C of 2.0 GPa or more is suitably used. These properties allow the film C to have an effect of suppressing transformation caused by the shrinkage of other layers to significantly suppress curl generation.

From the above-mentioned viewpoint, the thickness of the film C required to suppress curl generation is preferably 60 to 300 µm. From the viewpoint of the handleability and the cost of the film, the thickness is more preferably about 75 to 250 µm, further more preferably 100 to 200 µm. The elastic modulus at 23 °C of the film C is more preferably 2.0 to 10.0 GPa, further more preferably 2.0 to 8.0 GPa. The elastic modulus falling within the above-mentioned range can preferably produce deformation resistance to transformation caused by external force so as to sufficiently suppress curling in the protective sheet and the laminated article including the same. The elastic modulus herein refers to the tensile elastic modulus calculated from the slope of the straight-line part of the stress-strain curve, which can be determined by the tensile test in accordance with JIS K7161:1994.

Specifically, examples of the material of the film C include polyesters such as a polyethylene terephthalate (PET) and a polyethylene naphthalate (PEN); polyamides such as nylon 6, nylon 66, nylon 12, and copolymerized nylon; and an ethylene-vinyl acetate copolymer partial hydrolysate (EVOH), a polyimide, a polyetherimide, a polysulfone, a polyether sulfone, a polyether ether ketone, a polycarbonate, a polyvinyl butyral, a polyarylate, a fluorine resin, an acrylate resin, and a biodegradable resin. To improve the reinforcement effect of the elastic modulus of the resin, an inorganic material such as talc or an organic or an inorganic material such as a filler may be added.

When the film C is used for a solar cell protective sheet, the service temperature of the solar cell module increases to 85 to 90°C due to, for example, heat generation at the time of its power generation or the radiant heat of sunlight. Thus, the film C softens so as to lose the original capability to protect an original solar cell device during operation when the melting point of the film C is equal to or less than the service temperature. Accordingly, the film C preferably contains one or two or more kinds of resins selected from polyethylene naphthalate, polyethylene terephthalate, and the like, or polypropylene (PP), polylactic acid (PLA), poly vinyl fluoride (PVF), poly vinylidene fluoride (PVDF), cellulose acetate butyrate (CAB), and the like. The film C preferably contains this resin in a content of 50 % by mass or more. In addition, a resin composition in which an ultraviolet absorber and a colorant are combined with this resin is preferably used to form the film C but is not limited thereto.

### Adhesive layer

The protective sheet of the present invention has an adhesive layer 1 between the above-mentioned weather-resistant film A and the film B and an adhesive layer 2 between the film B and the film C.

The compositions and the thicknesses of the adhesive layer 1 and the adhesive layer 2 may or may not be the same. From the viewpoint of the balance of the protective sheet for the prevention of curling the compositions and the thicknesses are preferably the same. The adhesive layer 1 and the adhesive layer 2 are hereinafter sometimes merely referred to as "adhesive layer."

In producing the protective sheet, for example, the weather-resistant film is laminated to the film B (e.g., moisture-resistant film), and the film B is laminated to the film C, through an adhesive layer. In this case, an adhesive diluted by using a solvent is attached to each film, for example, to the base material sides of the film C and the film B in a predetermined thickness. The solvent is evaporated by drying at a temperature falling within the range of typically 70 to 140 °C to form an adhesive layer on each film. Then, another resin film or the like is attached to the adhesive layer. Finally, the protective sheet is produced through curing at a predetermined temperature. The curing is conducted a temperature falling within the range of 30 to 80 °C for from one day to one week.

In such a laminating process, the heat and the binding tension act on films to accumulate residual strain in the protective sheet. However, in the case of using the protective sheet as a solar cell protective sheet, the accumulated residual strain acts as the stress on each interlayer interface when the protective sheet for a solar cell protective sheet is used and stored under high-temperature and high-humidity environment. Particularly, residual strain accumulated in the films is a factor in shrinking the films under high-temperature and high-humidity environment, stressing the inorganic layer of the moisture-resistant film, developing a defect in the inorganic layer of the moisture-resistant film, and causing the moisture resistance performance to degrade.

Thus, the weather-resistant film (fluorine-based film) is preferably laminated to the moisture-resistant film through an adhesive layer having a certain level of softness and thickness from the viewpoint of less transmitting the stress due to the shrinkage of the resin films being caused by the residual strain to the inorganic layer under high-temperature and high-humidity environment, of protecting the inorganic layer, and of preventing the moisture resistance from degrading. Therefore, the adhesive layer preferably has a tensile storage elastic modulus of 5.0 × 10⁴ to 5.0 × 10⁵ Pa at a temperature of 100 °C, a frequency of 10 Hz, and a strain of 0.1%. Specifically, the tensile storage elastic modulus at 100 °C, a frequency of 10 Hz, and a strain of 0.1% of 5.0 × 10⁴ Pa or more can prevent the adhesive layer from flowing and uniformly maintain the layer thicknesses when component members forming the protective sheet, such as resin films, are laminated. The tensile storage elastic modulus at 100 °C, a frequency of 10 Hz, and a strain of 0.1% of 5.0 × 10⁵ Pa or less can prevent damage from an inorganic layer by allowing the adhesive layer to absorb the stress generated due to the shrinkage of films opposing each other through an adhesive layer. The tensile storage elastic modulus at a temperature of 100 °C, a frequency of 10 Hz, and a strain of 0.1% of the adhesive layer is preferably 7.0 × 10⁴ -5.0 × 10⁵ Pa, more preferably 1.0 × 10⁵ -5.0 × 10⁵ Pa.

From the viewpoint of maintaining the adhesive strength at normal temperature (20 °C), the tensile storage elastic modulus at a temperature of 20 °C, a frequency of 10 Hz, and a strain of 0.1% of the adhesive layer is 1.0 × 10⁶ Pa or more.

In addition, the degradation of the moisture resistance of the protective sheet may be caused by that of the adhesive. To prevent this, selecting an adhesive which is hardly hydrolyzed is effective.

From the above-mentioned viewpoint, in the present invention, it is preferable that adhesive used for the above-mentioned adhesive layer is a pressure sensitive adhesive having a certain level of softness and adhering by the van der Waals' force. The pressure sensitive adhesive is an adhesive adhering by only applying little pressure at normal temperature for a short time without water, solvent, heat, and simultaneously having a liquid nature for permeating into an adherend (liquidity) and a solid nature for resisting the peel-off (cohesion force). Adhesives such as a solvent-based adhesive, a thermoset adhesive, and a hotmelt adhesive are solidified by chemical reaction, solvent volatilization, temperature change, or the like. On the other hand, pressure sensitive adhesives are semisolid, which do not need the process of solidification. The state of pressure sensitive adhesives does not change after adhesion formation.

The pressure sensitive adhesive preferably contains an acrylic pressure sensitive adhesive and more preferably contains an acrylic pressure sensitive adhesive as a main component. The purport of the term "main component" herein is that any other component may be incorporated to such an extent that the effects of the present invention are not impaired. The term "main component," which does not impose any limitation on a specific content, generally refers to a component that accounts for 50 parts by mass or more, preferably 65 parts by mass or more, further more preferably 80 parts by mass or more and 100 parts by mass or less based on 100 parts by mass of the entire constituents of the adhesive layer.

The above-mentioned acrylic pressure sensitive adhesive is preferably formed of a polymer or a copolymer mainly containing a main monomer component having a low glass transition point (Tg) and imparting pressure sensitive adhesiveness, a comonomer component having a high Tg and imparting adhesiveness and cohesion force, and a functional group-containing monomer component for improving the crosslinking and the adhesiveness. The polymer or the copolymer hereinafter referred to as "acrylic (co)polymer.

"Examples of the main monomer component of the above-mentioned acrylic (co)polymer include acrylic esters such as ethyl acrylate, butyl acrylate, amyl acrylate, 2-ethylhexyl acrylate, and octyl acrylate. These may be used alone or in combination of two or more.

Examples of the comonomer component of the above-mentioned acrylic (co)polymer include methyl acrylate, methyl methacrylate, ethyl methacrylate, butyl methacrylate, methacrylate 2-ethylhexyl, cyclohexyl methacrylate, benzyl methacrylate, vinyl acetate, styrene, and acrylonitrile. These may be used alone or in combination of two or more.

Examples of the functional group-containing monomer component of the above-mentioned acrylic (co)polymer include carboxyl group containing monomers such as acrylic acid, methacrylic acid, maleic acid, and itaconic acid, hydroxyl group-containing monomers such as 2-hydroxyethyl (meth)acrylate, 2-hydroxypropyl (meth)acrylate, N-methylolacrylamide, acrylamide, methacrylamide, and glycidylmethacrylate. These may be used alone or in combination of two or more.

Examples of the initiator used for polymerizing the monomer component of the above-mentioned acrylic (co)polymer include azobisisobutylnitrile, benzoyl peroxide, di-t-butyl peroxide, and cumene hydroperoxide. The copolymerized form of the acrylic (co)polymer as the main component of the above-mentioned acrylic pressure sensitive adhesive is not limited in particular, which may be a random, block, or graft copolymer.

When the above-mentioned acrylic pressure sensitive adhesive is the above-mentioned acrylic (co)polymer, the mass-average molecular weight of the above-mentioned acrylic pressure sensitive adhesive is preferably 300,000 to 1,500,000, more preferably 400,000 to 1,000,000. The mass-average molecular weight falling within the above-mentioned range can secure the adhesion and the adhesive durability to an adherend so as to suppress floating or peeling.

In the above-mentioned acrylic (co)polymer, the content of a functional group-containing monomer component unit preferably falls within the range of 1 to 25 % by mass. The content falling within the above-mentioned range secures the adhesion and the degree of cross-linking to an adherend so as to adjust the tensile storage elastic modulus of the adhesive layer to 5.0 × 10⁴ to 5.0 × 10⁵ Pa at a temperature of 100 °C.

When the adhesive layer and the inorganic layer form a strong chemical bond, the inorganic layer is subjected to large stress due to the change of the viscoelasticity of the adhesive layer or the decomposition or the shrinkage of the adhesive layer coating. The factor in forming a chemical bond between the inorganic layer and the adhesive layer may be the reaction of the defective part of the inorganic layer such as an SiOₓ layer with a hydroxyl group in the adhesive layer. To suppress this, the number of reactive functional groups in the adhesive only has to be decreased. Thus, the number of unreacted functional groups after the adhesive layer is applied and cured is preferably decreased.

The adhesive layer in the present invention preferably contains an ultraviolet absorber.

In the present invention, the adhesive layer may be directly formed on the weather-resistant film, the film B, or the film C. Alternatively, the adhesive layer may be formed by applying the above-mentioned adhesive to the peel-off face of a release sheet and then attaching this adhesive layer to the weather-resistant film.

The adhesive to be attached (hereinafter referred to as "coating liquid") is based on an organic solvent, an emulsion, or a solventless adhesive. The organic solvent-based adhesive is preferable for the use of a solar cell sheet and the like requiring water resistance.

Examples of the organic solvent-based adhesive used for the organic solvent-based coating liquid include toluene, xylene, methanol, ethanol, isobutanol, n-butanol, acetone, methyl ethyl ketone, ethyl acetate, and tetrahydrofuran. These may be used alone or in combination of two or more.

The coating liquid is preferably prepared by using these organic solvents so that the solid content concentration falls within the range of 10 to 50 % by mass for the benefit and convenience of the application.

For example, the coating liquid can be applied by conventionally known coat methods such as a bar coat method, a roll coat method, a knife coat method, a roll-knife coat method, a die coat method, a gravure coating method, an air doctor coat method, and a doctor blade coat method.

After the application, the coating liquid is dried at 70 to 140 °C for about 1 to 5 minutes to form an adhesive layer.

The thickness of the adhesive layer is preferably 2 to 30 µm more preferably 4 to 25 µm further more preferably 6 to 20 µm from the viewpoint of obtaining sufficient adhesivity.

### Protective sheet

The protective sheet of the present invention includes a weather-resistant film A, an adhesive layer 1, a film B, an adhesive layer 2, a film C in the stated order, the film C having a thickness of 60 µm or more, in which the width W_{A} of the weather-resistant film, the width W_{B} of the film B, and the width W_{C} of the film C have a relationship of W_{A}>W_{C}>W_{B}. If the widths W_{A}, W_{B}, or W_{C} do not satisfy the above-mentioned relationship, or if the thickness of the film C is less than 60 µm, the difference among thermal shrinkage rates of the weather-resistant film, the film B, and the film C generates a marked curl in the obtained laminate or causes delamination so as not to solve the problem of the present invention.

As described above, in the present invention, the width W_{B} of the film B and the width W_{C} of the film C are required to be less than the width W_{A} of the weather-resistant film. The film C having an appropriate width W_{C} can suppress the shrinkage stress of the weather-resistant film so as to suppress curling. From the viewpoint of preventing delamination of the end faces after the laminate is formed, the ratio (W_{C}/W_{A}) of the width W_{C} to the width W_{A} is 0.70 or more and less than 1.0, and the difference (W_{A}-W_{C}) between the width W_{A} and the width W_{C} is 100 mm or less. It is preferable that W_{C}/W_{A} be 0.80 or more and less than 1.0 and that the difference between the width W_{A} and the width W_{C} be 80 mm or less. It is more preferable that W_{C}/W_{A} be 0.85 or more and 0.95 or less and that the difference between the width W_{A} and the width W_{C} be 50 mm or less.

Furthermore, in the present invention, the width W_{C} of the film C is required to be more than the width W_{B} of the film B. From the viewpoint of suppressing the shrinkage stress of the weather-resistant film so as to suppress curling and of obtaining a protective sheet and a laminate that have excellent appearance, it is preferable that the ratio (W_{B}/W_{C}) of the width W_{B} to the width W_{C} be 0.65 or more and less than 1.0 and that the difference (W_{C}-W_{B}) between the width W_{C} and the width W_{B} be 32 mm or less. It is more preferable that W_{B}/W_{C} be 0.75 or more and less than 1.0 and that the difference between the width W_{C} and the width W_{B} be 30 mm or less. It is further more preferable that W_{B}/ W_{C} be 0.80 or more and 0.99 or less and that the difference between the width W_{C} and the width W_{B} be 25 mm or less.

In the present invention, "the width of a film" means the length in the lateral direction to the longitudinal direction of a winded off film when the protective sheet is provided in a roll shape and the length of the short side of a film when the protective sheet is provided in a sheet shape.

In the present invention, from the viewpoint of the sufficient suppression of the shrinkage stress of the weather-resistant film, the handling, and the cost, the ratio of the thickness of the weather-resistant film to the thickness of the film C (thickness of weather-resistant film/thickness of film C) is 2.0 or less, more preferably 1.0 or less, further more preferably 0.75 or less, particularly preferably 0.20 or more and 0.75 or less.

The thickness of the entire protective sheet is not limited in particular but preferably 90 to 600 µm, more preferably 100 to 400 µm, further more preferably 120 to 320 µm.

In the case in which the film B is a moisture-resistant film having an inorganic layer in at least one side of the base material, the inorganic layer side of the moisture-resistant film is preferably laminated to the weather-resistant film through the adhesive layer 1 because the damage to the inorganic layer can be decreased when the protective sheet is stored and used.

### Encapsulating material-integrated protective sheet

The encapsulating material-integrated protective sheet of the present invention is formed by further laminating an encapsulating material layer to the film C side of the above-mentioned protective sheet. The encapsulating material-integrated protective sheet in which an encapsulating material layer is previously laminated can make vacuum lamination for an electronic device more efficient. Examples of the electronic device include display devices such as an EL device and a liquid crystal display device, a solar cell, and a touch panel.

For example, producing a solar cell module by using the protective sheet of the present invention can reduce the workload to individually laminate the front sheet, the encapsulating material, the electric power generating device, the encapsulating material, and the back sheet in vacuum lamination and thus can make the production of the solar cell module more efficient.

In the encapsulating material-integrated protective sheet of the present invention, examples of the encapsulating material forming the encapsulating material layer include a silicone resin-based encapsulating material, an ethylene-vinyl acetate copolymer, and a random copolymer of ethylene and an α-olefin. Examples of the α-olefin include propylene, 1-butene, 1-pentene, 1-hexene, 1-heptene, 1-octene, 1-nonene, 1-decene, 3-methyl-butene-1, and 4-methyl-pentene-1.

In the encapsulating material-integrated protective sheet, it is preferable that the width W_{D} of the encapsulating material layer be less than the width W_{A} of the above-mentioned weather-resistant and more than the width W_{C} of the film C. Accordingly, the end faces of the protective sheet-forming layer other than the weather-resistant film are encapsulated with an encapsulating material in vacuum lamination so as to prevent the moisture resistance of the protective sheet from decreasing and prevent the delamination of the protective sheet.

The thickness of the encapsulating material layer to be laminated is preferably 200 to 750 µm, more preferably 300 to 600 µm from the viewpoint of the protection of an electronic device.

Known methods can be used as the method of laminating an encapsulating material layer to the protective sheet of the present invention. For example, an encapsulating material layer only has to be laminated to the film C side of the protective sheet, optionally through an adhesive layer. For the adhesive layer, the same ones as the adhesives forming the above-mentioned adhesive layer or known adhesives such as a solvent-based adhesive, a thermosetting adhesive, and a hotmelt adhesive can be used. This adhesive preferably contains a polyurethane adhesive and more preferably contains a polyurethane adhesive as a main component.

### Roll-shaped article

The roll-shaped article of the present invention is formed by rolling up the above-mentioned protective sheet or the above-mentioned encapsulating material-integrated protective sheet of the present invention. The roll-shaped article can improve the subsequent processability, transportability, and productivity and easily protect the appearance.

The length of the roll is preferably 50 m or more, more preferably 100 m or more.

### Roll-shaped article with cover sheet

The roll-shaped article with a cover sheet of the present invention is formed by rolling up the above-mentioned protective sheet or the above-mentioned encapsulating material-integrated protective sheet of the present invention. The roll-shaped article with a cover sheet is formed by at least partially covering a part at which the weather-resistant film projects from the surface of the roll-shaped article with a cover sheet having a deflection length of 70 mm or less and a load bearing dent of 0.1 or less. The deflection length and the load bearing dent are determined under the following conditions.

### Deflection length

(1) A sample with a width of 20 mm and a length of 120 mm is collected.
(2) The sample is placed on and protruded from a platform so that the protuberance from the platform has a length of 100 mm, and then a 5 kg weight is added on the part of the sample on the platform to fix the sample.
(3) How much the end of the part of the sample being protruded from the platform hangs down from the platform is measured, and this measured length x (unit: mm) is determined as the deflection length.

The deflection length is an index of the deflectivity of a cover sheet.

The deflection length is preferably measured in numerically-stable condition, which is typically measured 5 minutes after the sample is fixed. The temperature condition of the measurement is suitably about 23 °C.

A plate, the bottom face of which has an area of 20 mm × 20 mm, is first placed on the part of the sample on the platform, and then a 5 kg weight is added on this plate. The height of the plate is 5 to 15 mm. The material of the plate is not limited in particular, which includes glass and iron.

### Load bearing dent

(1) A 100 mm square sample is collected.
(2) the sample is placed on a glass plate with a thickness of 20 mm, a 0.5 g steel ball with a diameter of 5 mm is added on the central part of the sample, and a 2 kg load is further added on the steel ball.
(3) The dent "d" in the sample (unit: µm) is measured, and the ratio "d/t" of the dent "d" to the thickness "t" (unit: µm) of the sample is determined as the load bearing dent.

The load bearing dent is an index of the hard to denting of a cover sheet.

As the dent "d" of the sample, the depth of the deepest part of the dent is measured.

The load bearing dent is preferably measured in numerically-stable condition, which is typically measured at 23 °C 24 hours after a steel ball is added on the sample, and then after a load is further added on the steel ball.

The above-mentioned solar cell protective sheet or the above-mentioned encapsulating material-integrated protective sheet of the present invention has projecting parts where the weather-resistant film is projected more than other protective sheet-forming layers because this film has such larger width. Thus, a roll-shaped article formed by rolling up the above-mentioned protective sheet or the above-mentioned encapsulating material-integrated protective sheet of the present invention also has such projecting parts. A roll-shaped article having such projecting parts may bend and wrinkle when transported.

The roll-shaped article with a cover sheet of the present invention prevents projecting parts from bending and wrinkling when transported by at least partially covering a part at which the weather-resistant film projects from the sides of the roll-shaped article.

The cover sheet only has to at least partially cover a part at which the weather-resistant film projects from the surface of the roll-shaped article. The cover sheet covers preferably 50% or more, more preferably 100% of this part. In the further more preferable aspect, the cover sheet covers the entire surface of the roll-shaped article.

The ratio of the width W_{K} of the cover sheet and the width W_{A} of the weather-resistant film (W_{K}/W_{A}) is 1 or more, more preferably 1.05 or more, further more preferably 1.15 or more.

From the viewpoint of handleability, W_{K}/W_{A} is preferably 1.5 or less, more preferably 1.3 or less. The projecting parts bend and wrinkle by a load mainly from the vertical direction(thickness direction) of the roll-shaped article. Thus, covering the surface of the roll-shaped article with a cover sheet can achieve an objective of the present invention. Furthermore, the sides of the roll-shaped article may be covered with a cover sheet in consideration of a load from the right and left direction(with direction) of the roll-shaped article.

The deflection length is preferably 60 mm or less, more preferably 50 mm or less, further more preferably 40 mm or less. The load bearing dent is preferably 0.05 or less, more preferably 0.03 or less.

From the viewpoint of the handleability when the surface of the roll-shaped article is covered with a cover sheet and of maintaining the fixation of the ends in the longitudinal direction of the cover sheet, it is preferable that the deflection length be 5 mm or more and that the load bearing dent be 0.01 or more, and it is more preferable that the deflection length is 10 mm or more and that the load bearing dent is 0.02 or more. "

As the cover sheet, plastic sheets formed of a polyolefin such as a homopolymer or a copolymer of ethylene, and propylene, butene; an amorphous polyolefin such as a cyclic polyolefin (Cyclo-Olefin-Polymer: COP); polyesters such as a polyethylene terephthalate (PET) and a polyethylene naphthalate (PEN); polyamides such as nylon 6, nylon 66, nylon 12, and copolymerized nylon; a polyimide, triacetyl cellulose (TAC), cellulose diacetate, cellulose acetate butyrate, polyethersulfone, polysulfone, polymethylpentene, polyvinyl chloride, polyvinyl acetal, polyether ketone, polymethyl methacrylate, polycarbonate, and polyurethane can be suitably used.

The thickness of the cover sheet is preferably 50 µm to 2 mm, more preferably 100 µm to 1 mm.

The cover sheet can cause blocking with the roll-shaped article. Particularly, the cover sheet located on the lower side of the roll-shaped article easily causes blocking between the roll-shaped article and the cover sheet by the weight of the roll-shaped article. Thus, the cover sheet preferably has a predetermined surface roughness. Specifically, the cover sheet has an arithmetic mean roughness Ra defined by JIS B 0601 of 50 nm or more.

The cover sheet has a predetermined strength and cushioning properties. Therefore, the foamed plastic films based on the plastic sheets given above are suitable.

The foamed plastic film is suitable in viewpoint of distinguishability from the opaque formed plastic film when the transparency of the laminate is high, in viewpoint of the excellent blocking resistance, and in viewpoint of the excellent handleability because of the lightweight.

In the present invention, the roll-shaped article only has to have a structure in which the cover sheet covers the surface of the roll-shaped article. However, the cover sheet is partially attached to the roll-shaped article by using a tape or an adhesive so as to remain the structure of the roll-shaped article. When the cover sheet covers the entire surface of the roll-shaped article, both the ends in the longitudinal direction of the cover sheet are preferably fixed with a tape or an adhesive.

In the present invention, the cover sheet and the weather-resistant film preferably meet the following conditions (a') and/or (b').
(a') deflection length of cover sheet / deflection length of weather-resistant film ≤ 2
(b') load bearing dent of cover sheet / load bearing dent of weather-resistant film ≤ 2

Meeting the above-mentioned condition (a') or (b') can more prevent projecting parts from bending and wrinkling. Meeting the above-mentioned conditions (a') and (b') can further more prevent a projecting parts from bending and wrinkling.

(a') The deflection length of cover sheet / deflection length of weather-resistant film is preferably 1 or less, more preferably 0.1 to 0.6. (b') The load bearing dent of cover sheet / load bearing dent of weather-resistant film is preferably 1 or less, more preferably 0.5 or less, further more preferably 0.01 to 0.2.

### Method of producing protective sheet

The method of producing a protective sheet of the present invention includes the following steps (1) to (4).
(1) A laminate X having an adhesive layer 1 is formed on one side of the film B and an adhesive layer 2 on the other side of the film B.
(2) Both the ends are slit in the width direction of the laminate X to form a laminate X'.
(3) A weather-resistant film A having a width W_{A} being more than the width W_{X'} of the laminate X' is attached to the adhesive layer 1 so that both the ends of the weather-resistant film A project from the respectively corresponding ends of the adhesive layer 1.
(4) A film C having a width W_{C} being more than the width W_{X'} of the laminate X' and less than the with W_{A} of the weather-resistant film A is attached to an adhesive layer 2 so that both the ends of the film C project from the respectively corresponding ends of the adhesive layer 2.

### Step (1)

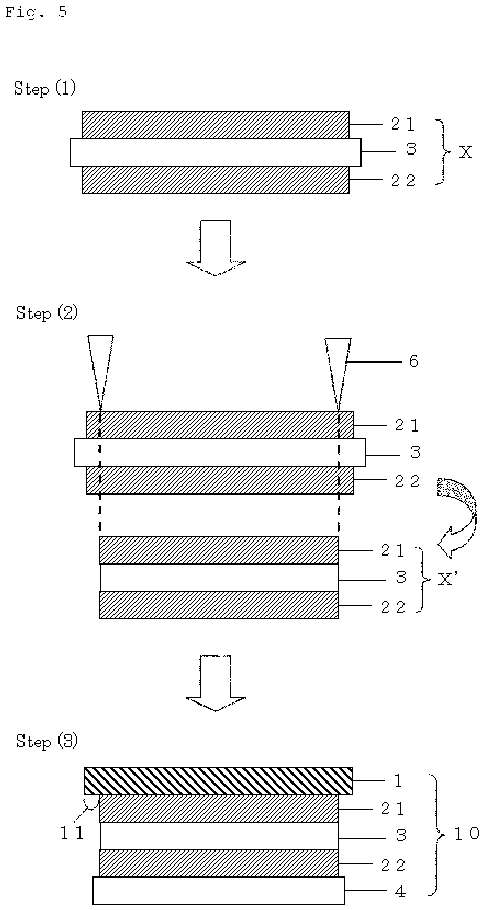

In the step (1), a laminate X having an adhesive layer 1 (21) is formed on one side of the film B (3) and an adhesive layer 2 (22) on the other side of the film B (3) as shown in FIG.5. To improve the slit workability in the step (2) and the handleability, a release sheet not shown in the figure is preferably disposed on the adhesive layer.

The laminate X can be produced by applying an adhesive layer composition to the film B (3) and drying this adhesive layer composition and drying this adhesive layer so as to form an adhesive layer. Being ionizing radiation curable, the adhesive layer composition is irradiated with ionizing radiation after dried.

The adhesive layer can also be formed by transferring an adhesive layer formed on another base material to the film B.

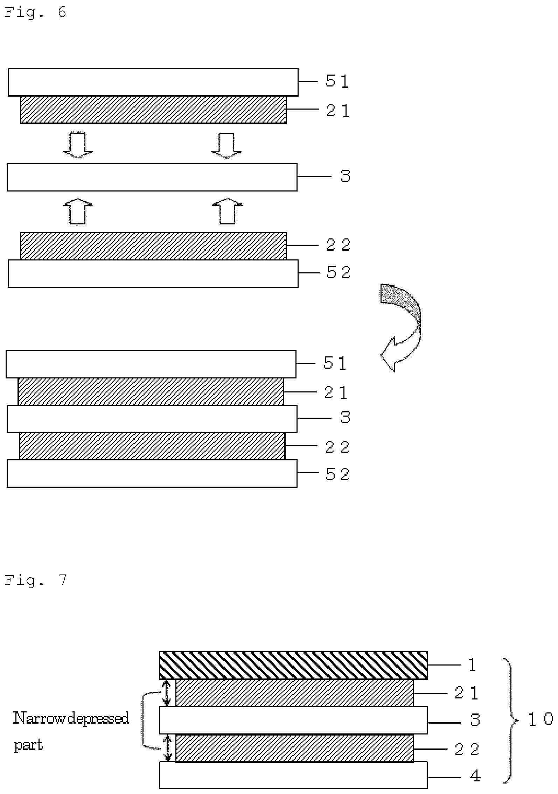

Having a release sheet, the laminate X can be produced by attaching a release sheet after the adhesive layer is formed on the film B (3). As shown in FIG 6, the laminate X is preferably produced by the following steps of (1-1) to (1-3) . According to the following method, when the film B is formed of a material with poor heat resistance, a material with excellent heat resistance as the release sheet is suitably used so as to easily produce a laminate X having an adhesive layer on the film B.
(1-1) An adhesive layer 1 (21) composition is applied to the release sheet 1 (51) to form an adhesive layer 1.
(1-2) An adhesive layer 2 (22) composition is applied to and dried on the release sheet 2 (52) to form an adhesive layer 2.
(1-3) The film B (3) is attached between the adhesive layer 1 (21) and the adhesive layer 2 (22) to form a laminate X.

When an adhesive layer composition is applied and dried on the film B or the release sheet to form an adhesive layer, the conveyance rate of the film B or the release sheet is preferably 5 to 15 m/minute. The conveyance rate of 5 m/minute or more can increase the production efficiency. The conveyance rate of 15 m/minute or less can prevent bubbles caused by the remaining solvent due to insufficient drying.

### Step (2)

In the step (2), both the ends in the width direction of the laminate X is slit to form a laminate X'.

As shown in FIG. 5, the widths of the adhesive layers (21, 22) are less than those of the film B (3) and the release sheet when the step (1) has been completed. This causes difference in level on the sides of the laminate X. If an adhesive layer composition is applied to equalize the widths of the adhesive layer and the base material, the adhesive layer composition wraps the back side of the base material, causing manufacturing failure. Thus, the difference caused in level on the sides of the laminate X is unavoidable due to manufacturing reasons.

If the weather-resistant film (1) or the film C (4) is attached while the sides of the laminate have difference in level, narrow depressed parts are formed on the both sides of the laminate having projecting parts as shown in FIG.7. In this case, when the laminate is vacuum-laminated by using an encapsulating material, air easily remains in these narrow depressed parts, easily causing bubbles.

On the other hand, slitting in the step (2) like the present invention eliminates difference in level on the sides of the laminate X' as shown in FIG.5. Even when the weather-resistant film (1) or the film C (4) is attached, narrow depressed parts cannot be formed on the sides of the laminate having projecting parts. Thus, bubbles can be prevented from being caused when vacuum lamination is conducted by using an encapsulating material.

At the position of the slit, all the materials forming the laminate X (the film B, the adhesive layer, and the release sheet) can be preferably slit.

The slitting method is not limited in particular and can be conducted by using a known slitter.

When the laminate X has a release sheet, it is preferable that the release sheet 1 be peeled off after the step (2) before the step (3) and that the release sheet 2 be peeled off after the step (2) before the step (4).

### Steps (3) and (4)

In the step (3), a weather-resistant film A having a width W_{A} being more than the width W_{X'} of the laminate X' is attached to an adhesive layer 1 so that both the ends of the weather-resistant film A project from the respectively corresponding ends of the adhesive layer 1.

In the step (4), a film C having a width W_{C} being more than the width W_{X'} of the laminate X' and less than the width W_{A} of the weather-resistant film A is attached to an adhesive layer 2 so that both the ends of the film C project from the respectively corresponding ends of the adhesive layer 2.

The laminate obtained after the steps (3) and (4) has projecting parts 11, in which the weather-resistant film (1) is projected in the width direction from both the ends of the adhesive layers (21, 22) and the moisture-resistant film (3), as shown in FIG.5. The step (3) may be conducted before or after the step (4).

The laminate X' can be attached to the weather-resistant film and the film C by using a known laminator. When this attachment, the widths of the laminate X', the weather-resistant film, and the film C are preferably adjusted by using an EPC (edge position control) device in order to increase the widths of the weather-resistant film and the film C evenly in right and left directions to the width of the laminate X'.

In the steps (3) and (4), the conveyance rate of the laminate X' and the weather-resistant film is preferably 20 to 30 m/minute. The conveyance rate of 20 m/minute or more can increase the production efficiency. The conveyance rate of 30 m/minute or less can easily adjust the width of the laminate X' and the weather-resistant film with an EPC device.

### Solar cell protective sheet

The solar cell protective sheet as a preferable aspect of the protective sheet of the present invention preferably has the above-mentioned weather-resistant film, the above-mentioned adhesive layer 1, a moisture-resistant film as the above-mentioned film B, the above-mentioned adhesive layer 2, and a protective film as the above-mentioned film C in the stated order. When used for the front sheet, the solar cell protective sheet preferably has a weather-resistant film on the exposed side.

In the solar cell protective sheet of the present invention, other layers may be laminated for the purpose of further improving various physical properties (such as flexibility, heat resistance, transparency, and adhesiveness), molding processability, or economic efficiency within a range not departing from the spirit of the present invention.

Any layers that can be used for a solar cell protective sheet can typically be used as other layers that can be laminated in the solar cell protective sheet of the present invention.

Examples of such layers include layers of an encapsulating material, a collecting material, a conductive material, a heat-transfer material, a moisture adsorption material, and the like. Various additives can optionally be added to these layers. Examples of the additive include an antistat, an ultraviolet absorber, a plasticizer, a lubricant, a filler, a colorant, a weather-resistant stabilizer, an anti-blocking agent, and an antioxidant but are not limited thereto.

The thickness of the solar cell protective sheet of the present invention is not limited in particular but typically 90 to 500 µm, preferably 100 to 400 µm, more preferably 150 to 350 µm, further more preferably 200 to 300 µm. The solar cell protective sheet is used in a sheet shape.

The solar cell protective sheet of the present invention can have an initial moisture resistance expressed by a moisture vapor permeability of preferably 0.1 g/m²/day or less, more preferably less than 0.05 g/m²/day, further more preferably less than 0.01 g/m²/day by using the moisture-resistant film having an inorganic layer in the base material as the film B and a moisture vapor permeability less than 0.1 g/m²/day as described above.

Thus, the solar cell protective sheet of the present invention has excellent initial moisture resistance. The protective sheet for a solar cell also has excellent moisture resistance and substantially prevents delamination when stored under high-temperature and high-humidity environment.

The moisture resistance in the present invention can be evaluated in accordance with the conditions of JIS Z0222 "Method of permeability test for moisture proof packing case" and JIS Z0208 "Testing methods for determination of the water vapor transmission rate of moisture-proof packaging materials (dish method)."

### Solar cell module and solar cell

As a surface protection sheet for a solar cell, the solar cell protective sheet of the present invention can be used alone or by being attached to a glass plate.

The solar cell module can be produced by using the solar cell protective sheet for the layer structure of the surface protection sheet such as the front sheet or the back sheet and by fixing the solar cell device.

As such a solar cell module, various types can be given as examples. For example, the solar cell module is preferably produced by using an encapsulating material, a solar cell device, and a back sheet when the solar cell protective sheet of the present invention is used as the front sheet. Specifically, example structures of the solar cell module include a structure composed of a front sheet (the solar cell protective sheet of the present invention)/an encapsulating material (encapsulating resin layer)/a solar cell device/an encapsulating material(encapsulating resin layer)/a back sheet; a structure in which an encapsulating material and a front sheet (the solar cell protective sheet of the present invention) are formed on a solar cell device formed on the inner periphery of the back sheet; and a structure in which an encapsulating material and a back sheet are formed on a solar cell device formed on the inner periphery of a front sheet (the solar cell protective sheet of the present invention), for example, an amorphous solar cell device formed on a transparent fluorine resin-based protective sheet by sputtering or the like.

Examples of the solar cell device include single-crystalline silicon-type devices, polycrystalline silicon-type devices, amorphous silicon-type devices, various III-V and II-VI group compound semiconductor-type devices such as gallium-arsenic, copper-indium-selenium, copper-indium-gallium-selenium, and cadmium-tellurium, dye sensitization-type devices, and organic thin-film devices.

Particularly, the solar cell protective sheet of the present invention is suitably used as a solar cell protective sheet for a solar cell module formed of a compound-type power-generating device, a flexible amorphous silicon solar cell module, and the like among electrical devices.

When a solar cell module is formed by using the solar cell protective sheet in the present invention, the moisture-resistant film is appropriately selected from a low moisture-resistant film with a moisture resistance expressed by a moisture vapor permeability of less than 0.1 g/m²/day to a high moisture-resistant film with a moisture resistance expressed by a moisture vapor permeability of less than 0.01 g/m²/day according to the type of the above-mentioned electric power generating device. Then, an adhesive having a suitable tensile storage elastic modulus and a suitable thickness is used to form the layer structure.

Other materials forming the solar cell module produced by using the protective sheet for a solar cell of the present invention is not limited in particular. The solar cell protective sheet of the present invention may be used for both the front sheet and the back sheet. Alternatively, a monolayered or a multilayered sheet such as a sheet formed of an inorganic material such as metal or glass and various thermoplastic resin films may be used for the front sheet or the back sheet. Examples of this metal include tin, aluminum, and stainless steel. Examples of this thermoplastic resin film include a monolayered and a multilayered sheet of a polyester, a fluorine-containing resin, a polyolefin. The surface of the front sheet and/or the back sheet can be subjected to known surface treatments such as priming treatment and corona treatment in order to improve the adhesiveness with the encapsulating material and other materials.

The solar cell module produced by using the solar cell protective sheet of the present invention will be explained as one example of the above-mentioned structure composed of a front sheet (the solar cell protective sheet of the present invention)/an encapsulating material/a solar cell device/an encapsulating material/a back sheet. The solar cell module is formed by laminating the solar cell protective sheet of the present invention, an encapsulating material, a solar cell device, a solar cell device, an encapsulating material, and a back sheet in the stated order from the sunlight-receiving side; and attaching a junction box (terminal box connecting a wiring for transmitting electricity generated from the solar cell device to outside) to the lower surface of the back sheet. The solar cell devices are coupled with each other by a wiring for conducting a generated current to outside. The wiring is taken to outside through a through-hole provided for the back sheet so as to be connected to the junction box.

As the method of producing a solar cell module, known production methods can be applied without any particular limitation. The method generally includes the steps of laminating the solar cell protective sheet of the present invention, an encapsulating resin layer, a solar cell device, an encapsulating resin layer, and a back sheet in the stated order, suctioning the laminated layer under vacuum, and crimping this laminate under heat. For example, the vacuum suction and heat-crimping are conducted with a vacuum laminator by heating at preferably 130 to 180 °C, more preferably 130 to 150 °C, deaerating for 2 to 15 minutes, pressing under 0.05 to 0.1 MPa for preferably 8 to 45 minutes, more preferably 10 to 40 minutes.

Batch manufacturing facilities and roll-to-roll manufacturing facilities can also be applied.

The solar cell module produced by using the solar cell protective sheet of the present invention can be variously used regardless of indoor or outdoor, for example, a small solar cell typically used for a mobile device, a large solar cell installed on a roof or a rooftop despite the type and the module form of a solar cell to be applied.

Moreover, the protective sheet of the present invention other than the above-mentioned solar cells can be expanded on the use as industrial materials such as a liquid crystal display device, an electromagnetic shield, a touch panel, an organic device, a color filter, and a vacuum insulation material.

### Examples

The present invention will be more specifically explained with reference to Examples but not limited to Examples and Comparative Examples. Various physical properties were measured and evaluated as follows.

### Measurement of physical properties

### (1) Tensile elastic modulus of film C

The film C was formed to tensile test dumbbell, the parallel part of which has a width of 10 mm and a length of 40 mm based on JIS K6734:2000 and then subjected to tensile test in accordance with JIS K7161:1994. The value was calculated from the slope of the straight-line part of the stress-strain curve as the tensile elastic modulus.

### (2) Tensile storage elastic modulus of adhesive layer

The adhesive was applied to the silicone release PET film so that the density is 10 g/m². This adhesive was cured at 40 °C for 4 days and further maintained at 150 °C for 30 minutes to form the adhesive layer (pressure sensitive adhesive layer) . Then, only the adhesive layer was removed. Subsequently, a predetermined number of adhesive layers were overlayed so that the thickness is 200 µm to prepare a sample (length: 4 mm, width: 60 mm, thickness: 200 µm). The stress to the strain applied to the obtained sample was measured at from -100 to 180 °C with a viscoelasticity-measurement device available under the trade name "Viscoelasticity Spectrometer DVA-200" available from IT Keisoku Co., Ltd. at an oscillation frequency of 10 Hz, a strain of 0.1%, a rate of temperature increase rate of 3°C/minute, and a chuck-to-chuck distance of 25 mm in the lateral direction. The tensile storage elastic modulus (MPa) at a temperature of 100 °C, a frequency of 10 Hz, and a strain of 0.1% was measured from the obtained data.

### (3) Curl evaluation

A protective sheet was placed flat in an oven maintained at 150 °C and left for 5 minutes. Then, the heights of the four corners of the protective sheet were measured with a micro caliper. The average of the measured values of the four corners was determined as the curl value. The marked line was determined as the face where the platform is in contact with the protective sheet when the protective sheet is placed on a horizontal platform so that the weather-resistant film faces up.

The effect in the suppression of curl generation was evaluated from the following criteria based on the measurement result of the curl value.
AA: The curl value is 5 to 20 mm.
A: The curl value is more than 20 mm and 30 mm or less.
F: The curl value is more than 30 mm.

### (4) Appearance after vacuum lamination

A glass, an encapsulating material, and a protective sheet were laminated in the stated order with the end faces fitted to the end faces of the weather-resistant film. The weather-resistant film was set, facing outside. Then, vacuum lamination was conducted under the condition of 150 °C × 15 minutes. Subsequently, the appearance was observed and evaluated by the following criteria.
AAA: The encapsulating material is wrapped around between the film C and the weather-resistant film, and no wrinkles are observed in the projecting parts of the weather-resistant film.
AA: The encapsulating material is wrapped around between the film C and the weather-resistant film, but a wrinkle is observed in the projecting parts of the weather-resistant film.
A: The encapsulating material is not wrapped around between the film C and the weather-resistant film.
F: The encapsulating material and the weather-resistant film are delaminated.

### Structural film

### Weather-resistant film

### A-1: fluorine-based resin film

Tetrafluoroethylene-ethylene copolymer (ETFE) film (trade name "Aflex 50 MW1250 DCS" available from ASAHI GLASS CO., LTD., thickness: 50 µm, thermal shrinkage rate at 150 °C: 3.0%)

### A-2: PET film

Biaxially-oriented polyester film (trade name: T100 available from Mitsubishi Plastics, Inc., thickness: 50 µm, thermal shrinkage rate at 150 °C: 1.0%)

### Film C

C-1: Biaxially-oriented polyester film (trade name: T100 available from Mitsubishi Plastics, Inc., thickness: 50 µm, thermal shrinkage rate at 150 °C: 0.3%) subjected to heat-set treatment at 170 °C
C-2: Biaxially-oriented polyester film (trade name: T100 available from Mitsubishi Plastics, Inc., thickness: 75 µm, thermal shrinkage rate at 150 °C: 0.3%) subjected to heat-set treatment at 170 °C
C-3: Biaxially-oriented polyester film (trade name: T100 available from Mitsubishi Plastics, Inc., thickness: 125 µm, thermal shrinkage rate at 150 °C: 0.3%) subjected to heat-set treatment at 170 °C
C-4: Isotactic polypropylene resin

Titanium oxide (8 % by mass) as a whitening agent and ultrafine particulate titanium oxide (particle-size: 0.01 to 0.06 µm, 3 % by mass) as an ultraviolet absorber were added in the isotactic polypropylene resin. Additionally, a required additive was added in this mixture. The mixture was sufficiently mixed to prepare a polypropylene resin composition. Then, the polypropylene resin composition was extruded with an extruder to produce an unoriented polypropylene resin film with a thickness of 125 µm.

### Pressure sensitive adhesive

With a reactor equipped with a thermometer, a stirrer, a reflux cooling tube, and a nitrogen gas inlet tube, 0.3 parts by mass of azobisiso butyronitrile were added in a mixed solution of 90 parts by mass of butyl acrylate, 10 parts by mass of acrylic acid, 75 parts by mass of ethyl acetate, and 75 parts by mass of toluene, and the mixture was polymerized at 80 °C under a nitrogen gas atmosphere for 8 hours. After the reaction ends, the solid content was adjusted to 30 % by mass with toluene to obtain a resin with a mass-average molecular weight of 500,000. 1.0 part by mass of CORONATE L (trade name of Nippon Polyurethane Industry Co., Ltd, solid content: 75 parts by mass) was added in 100 parts by mass of the obtained resin as an isocyanate-based crosslinking agent to prepare a pressure sensitive adhesive.

### Film B

### B-1

The following coating liquid was applied to and dried on the corona treated side of a biaxially-oriented polyethylene naphthalate film with a thickness of 12 µm ("Q51 C12" available from Teijin DuPont Films Japan Limited) used as the base material to form an anchor coat layer with a thickness of 0.1 µm.

Then, SiO was evaporated by heating under 1.33 × 10⁻³ Pa (1 × 10⁻⁵Torr) with a vacuum deposition device to obtain a moisture-resistant film having an SiOₓ (x=1.5) thin layer with a thickness of 50 nm on the anchor coat layer. The moisture vapor permeability of this moisture-resistant filmB-1 was 0.01 g/m²/day.

### B-2

Biaxially-oriented polyester film (trade name: T100 available from Mitsubishi Plastics, Inc., thickness: 50 µm, thermal shrinkage rate at 150 °C: 0.3%) subjected to heat-set treatment at 170 °C

### Coating liquid

220 g of a polyvinyl alcohol resin "Gohsenol" available from Nippon Synthetic Chemical Industry Co., Ltd., (saponification value: 97.0 to 98.8 % by mole, polymerization degree: 2400) was added to 2810 g of ion exchange water and dissolved by heating. Then, 645 g of 35 % by mole of hydrochloric acid was added in the aqueous solution while being stirred at 20 °C. Subsequently, 3.6 g of butyraldehyde was added while being stirred at 10 °C. After 5 minutes, 143 g of acetaldehyde was added dropwise while being stirred to precipitate resin microparticles. After maintained at 60 °C for 2 hours, the liquid was cooled, neutralized with sodium hydrogen carbonate, washed with water, and dried to obtain polyvinyl acetoacetal resin powders (degree of acetalization: 75 % by mole).

The obtained resin powders were mixed with an isocyanate resin "Sumidur N-3200" available from Sumitomo Bayer Urethane Co., Ltd as a crosslinking agent so that the equivalence ratio of the isocyanate group to the hydroxyl group is 1:2.

### Encapsulating material

### D-1: EVASKY S11 available from Bridgestone Corporation (thickness: 500 µm, melting point: 69.6 °C)

### Glass

The solar cell cover glass TCB09331 (thickness: 3.2 mm) available from AGC Fabritech Co., LTD., was cut into to the same size as that of each of the weather-resistant films used in Examples and Comparative Examples.

### Example 1

The pressure sensitive adhesive was applied to a silicone release PET film with a thickness of 38 µm (NS-38+A available from Nakamoto Packs Co., Ltd., melting point: 262 °C, width: 328 mm) so that the thickness is 10 µm. Then, the pressure sensitive adhesive was dried to form a pressure sensitive adhesive layer (adhesive layer 1). The SiOₓ side of the film B-1 with a thickness 12 µm (moisture-resistant film, width: 328 mm) was attached to the adhesive layer 1. The pressure sensitive adhesive was applied to the SiOₓ back side of the moisture-resistant film with a silicone release PET film so that the thickness is 10 µm, and the pressure sensitive adhesive was dried to form a pressure sensitive adhesive layer (adhesive layer 2). Then, a PET film with a thickness of 125 µm and a low thermal shrinkage rate C-3 (width: 330 mm) was attached to the adhesive layer 2.

Subsequently, the silicone release PET film on the SiOₓ side of the film B-1 was peeled off, and the weather-resistant film A-1 with a thickness of 50 µm (width: 380 mm, thermal shrinkage rate: 3.0%) was attached to the adhesive layer 1. Then, the laminate was cured at 40 °C for 4 days to prepare the protective sheet E-1 with a thickness of 207 µm. The lengths of the weather-resistant film A-1, the film B-1, the adhesive layer 1, and the adhesive layer 2 is approximately the same.

The prepared protective sheet E-1 was placed flat in an oven maintained at 150 °C and left for 5 minutes to measure the curl value. The glass, the encapsulating material, and the protective sheet E-1 were further laminated in the stated order so that the weather-resistant film is disposed on the exposed side. Then, vacuum lamination was conducted on the condition of 150 °C × 15 minutes, and the appearance was evaluated. Table 1 shows the relationship among the structure, the width, and the thickness of each of the layers. Table 2 shows the result.

### Example 2

Except for setting the width of the film B-1 to 326 mm, a protective sheet E-2 with a thickness of 207 µm was prepared in the same way as Example 1. Table 1 shows the relationship among the structure, the width, and the thickness of each of the layers. Table 2 shows the result from the same evaluation as that conducted in Example 1.

### Example 3

Except for setting the width of the film B-1 to 320 mm, a protective sheet E-3 with a thickness of 207 µm was prepared in the same way as Example 1. Table 1 shows the relationship among the structure, the width, and the thickness of each of the layers. Table 2 shows the result from the same evaluation as that conducted in Example 1.

### Example 4

Except for setting the width of the film B-1 to 310 mm, a protective sheet E-4 with a thickness of 207 µm was prepared in the same way as Example 1. Table 1 shows the relationship among the structure, the width, and the thickness of each of the layers. Table 2 shows the result from the same evaluation as that conducted in Example 1.

### Example 5

Except for setting the width of the film B-1 to 296 mm, a protective sheet E-5 with a thickness of 207 µm was prepared in the same way as Example 1. Table 1 shows the relationship among the structure, the width, and the thickness of each of the layers. Table 2 shows the result from the same evaluation as that conducted in Example 1.

### Example 6

Except for setting the widths of the film B-1, the PET film with a low thermal shrinkage rate C-3, and the weather-resistant film A-1 to 70 mm, 90 mm, and 100 mm, respectively, a protective sheet E-6 with a thickness of 207 µm was prepared in the same way as Example 1. Table 1 shows the relationship among the structure, the width, and the thickness of each of the layers. Table 2 shows the result from the same evaluation as that conducted in Example 1.

### Example 7

Except for setting the widths of the film B-1 and the PET film with a low thermal shrinkage rate C-3 to 346 mm and 350 mm, respectively, a protective sheet E-7 with a thickness of 207 µm was prepared in the same way as Example 1. Table 1 shows the relationship among the structure, the width, and the thickness of each of the layers. Table 2 shows the result from the same evaluation as that conducted in Example 1.

### Example 8

Except for setting the width of the PET film with a low thermal shrinkage rate C-3 to 300 mm, a protective sheet E-8 with a thickness of 207 µm was prepared in the same way as Example 1. Table 1 shows the relationship among the structure, the width, and the thickness of each of the layers. Table 2 shows the result from the same evaluation as that conducted in Example 1.

### Example 9

Except for changing the weather-resistant film A-1 to the PET film A-2 (width: 380 mm, thermal shrinkage rates: 1.5%), a protective sheet E-9 with a thickness of 207 µm was prepared in the same way as Example 2. Table 1 shows the relationship among the structure, the width, and the thickness of each of the layers. Table 2 shows the result from the same evaluation as that conducted in Example 1.

### Example 10

Except for changing the PET film with a low thermal shrinkage rate C-3 to the biaxially-oriented polyester film C-2 with a thickness of 75 µm, a protective sheet E-10 with a thickness of 157 µm was prepared in the same way as Example 2. Table 1 shows the relationship among the structure, the width, and the thickness of each of the layers. Table 2 shows the result from the same evaluation as that conducted in Example 1.

### Example 11

Except for changing the PET film with a low thermal shrinkage rate C-3 to the isotactic polypropylene resin C-4 (width: 330 mm, elastic modulus: 1.5 GPa), a protective sheet E-11 with a thickness of 207 µm was prepared in the same way as Example 2. Table 1 shows the relationship among the structure, the width, and the thickness of each of the layers. Table 2 shows the result from the same evaluation as that conducted in Example 1.

### Example 12

Except for changing the film B-1 to the PET film with a low thermal shrinkage rate B-2 with a thickness of 50 µm (width: 326 mm), a protective sheet E-12 with a thickness of 245 µm was prepared in the same way as Example 2. Table 1 shows the relationship among the structure, the width, and the thickness of each of the layers. Table 2 shows the result from the same evaluation as that conducted in Example 1.

### Comparative Example 1

Except for setting the width of the film B-1 to 330 mm, a protective sheet E-13 with a thickness of 207 µm was prepared in the same way as Example 1. Table 1 shows the relationship among the structure, the width, and the thickness of each of the layers. Table 2 shows the result from the same evaluation as that conducted in Example 1.

### Comparative Example 2

Except for setting the widths of the film B-1 and the PET film with a low thermal shrinkage rate C-3 to 376 mm and 380 mm, respectively, a protective sheet E-14 with a thickness of 207 µm was prepared in the same way as Example 1. Table 1 shows the relationship among the structure, the width, and the thickness of each of the layers. Table 2 shows the result from the same evaluation as that conducted in Example 1.

### Comparative Example 3

Except for changing the PET film with a low thermal shrinkage rate C-3 to the biaxially-oriented polyester film C-1 with a thickness of 50 µm, a protective sheet E-15 with a thickness of 132 µm was prepared in the same way as Example 2. Table 1 shows the relationship among the structure, the width, and the thickness of each of the layers. Table 2 shows the result from the same evaluation as that conducted in Example 1.

### Table 1

**Table 1**

| | Protective material No. | Weather-resistant film | | | | Film B | | | Film C | | | | Laminate | | | | |
|---|---|---|---|---|---|---|---|---|---|---|---|---|---|---|---|---|---|
| | | Type | Width mm | Thickness µm | Shrinkage rate % | Type | Width mm | Thickness µm | Type | Width mm | Thickness µm | Elastic modulus GPa | Width | | | | Thickness |
| | | | | | | | | | | | | | W_{A}-W_{C} | W_{C}-W_{B} | W_{C}/W_{A} | W_{B}/W_{C} | Whether resistant film/ Film C |
| Example 1 | E-1 | A-1 | 380 | 50 | 3.0 | B-1 | 328 | 12 | 0-3 | 330 | 125 | 4 | 50 | 2 | 0.868 | 0.994 | 0.40 |
| Example 2 | E-2 | A-1 | 380 | 50 | 3.0 | B-1 | 326 | 12 | C-3 | 330 | 125 | 4 | 50 | 4 | 0.868 | 0.988 | 0.40 |
| Example 3 | E-3 | A-1 | 380 | 50 | 3.0 | B-1 | 320 | 12 | 0-3 | 330 | 125 | 4 | 50 | 10 | 0.868 | 0.970 | 0.40 |
| Example 4 | E-4 | A-1 | 380 | 50 | 3.0 | B-1 | 310 | 12 | C-3 | 330 | 125 | 4 | 50 | 20 | 0.868 | 0.939 | 0.40 |
| Example 5 | E-5 | A-1 | 380 | 50 | 3.0 | B-1 | 296 | 12 | C-3 | 330 | 125 | 4 | 50 | 34 | 0.868 | 0.897 | 0.40 |
| Example 6 | E-6 | A-1 | 100 | 50 | 3.0 | B-1 | 70 | 12 | C-3 | 90 | 125 | 4 | 10 | 20 | 0.900 | 0.778 | 0.40 |
| Example 7 | E-7 | A-1 | 380 | 50 | 3.0 | B-1 | 346 | 12 | C-3 | 350 | 125 | 4 | 30 | 4 | 0.921 | 0.989 | 0.40 |
| Example 8 | E-8 | A-1 | 380 | 50 | 3.0 | B-1 | 296 | 12 | C-3 | 300 | 125 | 4 | 80 | 4 | 0.789 | 0.987 | 0.40 |
| Example 9 | E-9 | A-2 | 380 | 50 | 1.0 | B-1 | 326 | 12 | C-3 | 330 | 125 | 4 | 50 | 4 | 0.868 | 0.988 | 0.40 |
| Example 10 | E-10 | A-1 | 380 | 50 | 3.0 | B-1 | 326 | 12 | C-2 | 330 | 75 | 4 | 50 | 4 | 0.868 | 0.988 | 0.67 |
| Example 11 | E-11 | A-1 | 380 | 50 | 3.0 | B-1 | 326 | 12 | C-4 | 330 | 125 | 1.5 | 50 | 4 | 0.868 | 0.988 | 0.40 |
| Example 12 | E-12 | A-1 | 380 | 50 | 3.0 | B-2 | 326 | 50 | C-3 | 330 | 125 | 4 | 50 | 4 | 0.868 | 0.988 | 0.40 |
| Comparative Example 1 | E-13 | A-1 | 380 | 50 | 3.0 | B-1 | 330 | 12 | C-3 | 330 | 125 | 4 | 50 | 0 | 0.868 | 1.000 | 0.40 |
| Comparative Example 2 | E-14 | A-1 | 380 | 50 | 3.0 | B-1 | 376 | 12 | 0-3 | 380 | 125 | 4 | 0 | 4 | 1.000 | 0.989 | 0.40 |
| Comparative Example 3 | E-15 | A-1 | 380 | 50 | 3.0 | B-1 | 326 | 12 | C-1 | 330 | 50 | 4 | 50 | 4 | 0.868 | 0.988 | 1.00 |

### Table 2

**Table 2**

| | Protective material No. | Curl [m m] | Effect in suppressing curl generation | Appearance after vacuum lamination |
|---|---|---|---|---|
| Example 1 | E-1 | 20 | AA | AAA |
| Example 2 | E-2 | 17 | AA | AAA |
| Example 3 | E-3 | 13 | AA | AAA |
| Example 4 | E-4 | 17 | AA | AA |
| Example 5 | E-5 | 12 | AA | A |
| Example 6 | E-6 | 18 | AA | AA |
| Example 7 | E-7 | 12 | AA | AAA |
| Example 8 | E-8 | 22 | A | AA |
| Example 9 | E-9 | 5.4 | AA | AAA |
| Example 10 | E-10 | 28 | A | AA |
| Example 11 | E-11 | 25 | A | AA |
| Example 12 | E-12 | 20 | AA | AA |
| Comparative Example 1 | E-13 | 40 | F | AAA |
| Comparative Example 2 | E-14 | 8.4 | AA | F |
| Comparative Example 3 | E-15 | 80 | F | AA |

As is apparent from Table 1, Examples 1 to 12 falling within the scope of the present invention significantly prevented curl generation and had excellent appearance after vacuum lamination. On the other hand, Comparative Examples 1 to 3 in which the widths of the layers forming the protective sheet depart from the scope of the present invention degraded the performance of prevention of curl generation and the appearance after vacuum lamination.

### Example 13

A pressure sensitive adhesive was applied to the film C-3 side of the protective sheet E-1 prepared in Example 1 so that the thickness is 5 µm, and then dried to form a pressure sensitive layer (adhesive layer). An encapsulating material D-1 with a width of 350 mm was laminated to the formed adhesive layer. These layers were cured at 40 °C for 4 days to prepare an encapsulating material-integrated protective sheet F-1 with a thickness of 700 µm.

In the obtained encapsulating material-integrated protective sheet F-1, the adhesiveness between the protective sheet E-1 and the encapsulating material layer was excellent. Moreover, for the encapsulating material-integrated protective sheet F-1, the appearance after vacuum lamination was evaluated. From the evaluation, the encapsulating material-integrated protective sheet F-1 had superior workability to Example 1 and was rated as high as Example 1.

### Cover sheets K-1 to K-4

The following cover sheets were prepared.
K-1: Foamed polyethylene sheet (poren sheet available from Poren chemical industry, thickness: 700 µm, width: 480 mm)
K-2: Polypropylene film (polypropylene sheet (product code: 07-175-02) available from KOKUGO Co., Ltd., thickness: 500 µm, width: 480 mm)
K-3: Transparent polyester film (Diafoil T100 available from Mitsubishi Plastics, Inc., thickness: 380 µm, width: 480 mm)
K-4: Polyethylene film (product code: 125-18-18 to 01 available from TGK company, thickness: 30 µm, width: 250 mm)

### (5) Deflection length

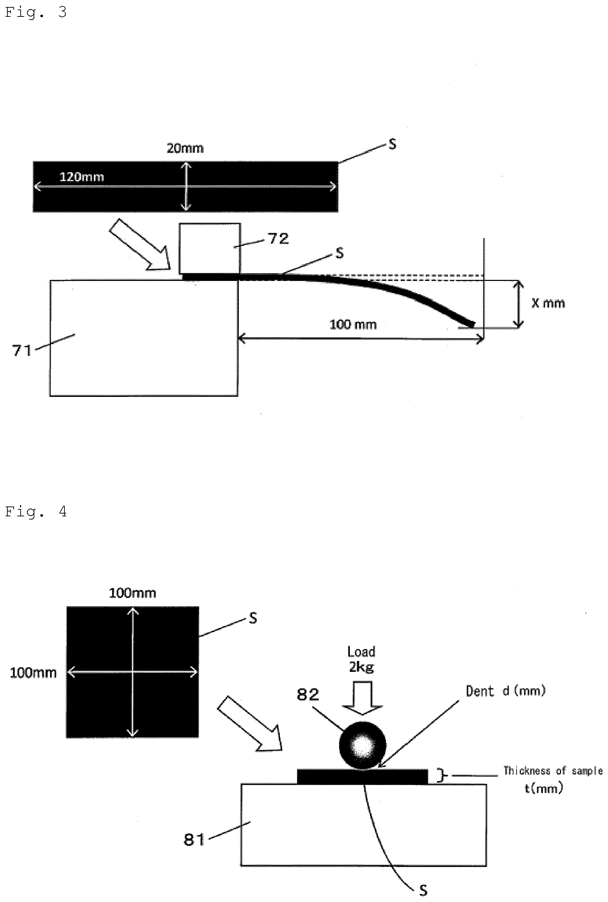

As shown in FIG.3, each of the cover sheets and the weather-resistant film A-1 were cut into a strip with a width of 20 mm and a length of 120 mm to prepare a measurement sample S of the cover sheet and the weather-resistant film A-1. Subsequently, the sample S was placed on and protruded from a platform 71 with a height of 100 mm or more so that the protuberance from the platform has a width of 20 mm and a length of 100 mm. An iron plate with a height of 10 mm, the bottom face of which has an area of 20 mm × 20 mm, was placed on the part of the sample on the platform. Then, a 5 kg weight 72 was added on the iron plate. How much the end of the part of the sample S being protruded from the platform 71 hangs down from the platform was measured, and this measured length x (unit: mm) was determined as the deflection length.

Five minutes after the sample was fixed, the measurement was conducted at 23 °C. Table 3 shows the results.

### (6) Load bearing dent

As shown in FIG.4, each of the cover sheet and the weather-resistant film A-1 were cut into a 100 mm square to prepare a measurement sample S of the cover sheet and the weather-resistant film A-1. Then, the sample S was placed on a glass plate 81 with a thickness of 20 mm, a 0.5 g steel ball 82 with a diameter of 5 mm was added on the central part of the sample, and a 2 kg load was further added on the steel ball 82. After 24 hours, the depth of the deepest part of the dent "d" in the sample S (unit: µm) was measured at 23 °C. The ratio "d/t" of the dent "d" to the thickness "t" (unit: µm) of the sample S was determined as the load bearing dent. Table 3 shows the results.

### (7) Bending resistance of projecting parts

For each of the roll-shaped articles with a cover sheet obtained in Examples 14 to 16 and Reference Example 1, a 5 kg load was applied to the cover sheet on the parts corresponding to the projecting parts for 24 hours. The weather-resistant film was visually observed and evaluated by the following criteria. Table 3 shows the results.
(AA): The parts protruding more than the film B of the weather-resistant film are not bent.
(F): The parts protruding more than the film B of the weather-resistant film are bent.

### (8) Fixation of ends of cover sheet (handleability)

The roll-shaped articles with a cover sheet obtained in Examples 14 to 16 and Reference Example 1 were evaluated by the following criteria. Table 3 shows the results.
(AA) : The ends of the cover sheet can be fixed for 3 days or more.
(A): The ends of the cover sheet cannot be fixed for 3 days.

### Example 14

The pressure sensitive adhesive was applied to a silicone release PET film with a thickness of 38 µm (NS-38+A available from Nakamoto Packs Co., Ltd., melting point: 262 °C, width: 328 mm) so that the thickness is 10 µm. Then, the pressure sensitive adhesive was dried to form a pressure sensitive adhesive layer (adhesive layer 1), and the SiOₓ side of the film B-1 with a thickness 12 µm (moisture-resistant film, width: 328 mm) was attached to the adhesive layer 1. The pressure sensitive adhesive was applied to the SiOₓ back side of the moisture-resistant film with a silicone release PET film so that the thickness is 10 µm, and the pressure sensitive adhesive was dried to form a pressure sensitive adhesive layer (adhesive layer 2). Then, a PET film with a thickness of 125 µm and a low thermal shrinkage rate C-3 (width: 330 mm) was attached to the adhesive layer 2.

Subsequently, the silicone release PET film on the SiOₓ side of the film B-1 was peeled off, and the weather-resistant film A-1 with a thickness of 50 µm (width: 380 mm, thermal shrinkage rate: 3.0%) was attached to the adhesive layer 1. Then, the laminate having the structure of weather-resistant film A-1/adhesive layer 1/film B-1/adhesive 2/film C-3 was obtained.

The laminate was winded on a core with an outer diameter of 172.4 mm to obtain a 200 m roll-shaped article. Subsequently, the roll-shaped article was cured at 40 °C for 4 days. The entire surface of the cured roll-shaped article was covered with the cover sheet K-1. The ends of the roll-shaped article were fixed with a piece of tape (Pyolan Tape available from DIATEX Co., Ltd., cut into 50 mm in width × 100 mm in length) to obtain a roll-shaped article with a cover sheet of Example 14.

### Example 15

Except for using the cover sheet K-2, the roll-shaped article with a cover sheet of Example 15 was obtained in the same way as Example 14.

### Example 16

Except for using the cover sheet K-3, the roll-shaped article with a cover sheet of Example 16 was obtained in the same way as Example 14.

### Reference Example 1

Except for using the cover sheet K-4, the roll-shaped article with a cover sheet of Reference Example 1 was obtained in the same way as Example 14.

### Table 3

**Table 3**

| | Weathe r-resistant film | | Cover sheet | | | Cover sheet/ Weather resistant film | | Bending resistance | Handleability |
|---|---|---|---|---|---|---|---|---|---|
| | Deflection length (mm) | Load bearing dent | Type | Deflection length (mm) | Load bearing dent | Deflection length (mm) | Load bearing dent | | |
| Example 14 | 95 | 0.04 | K-1 | 10 | 0.03 | 0.11 | 0.75 | AA | AA |
| Example 15 | 95 | 0.04 | K-2 | 33 | 0.02 | 0.34 | 0.50 | AA | AA |
| Example 16 | 95 | 0.04 | K-3 | 38 | 0.01 | 0.40 | 0.25 | AA | A |
| Reference Example 1 | 95 | 0.04 | K-4 | 98 | 0.10 | 1.03 | 2.5 | F | AA |

As shown in Table 3, the roll-shaped articles with a cover sheet of Examples 14 to 16 had excellent bending resistance and excellent handleability. For the laminates (protective sheet) forming roll-shaped articles with a cover sheet of Examples 14 to 16, the appearance after vacuum lamination was evaluated in the same manner as Example 1. From the evaluation, the laminates were rated as high as Example 1.

### (10) Air bubbles

The glass, the encapsulating material, and each of the protective sheets (E-16, E-17, and E-13) of Examples 17 and 18 and Comparative Example 1 were laminated in the stated order so that the weather-resistant film is disposed on the exposed side. With a vacuum laminator (LM-30×30 available from MPC Incorporated), the vacuum suction was conducted by heating at 150 °C, deaerating for 5 minutes, pressing under 0.1 MPa for 10 minutes. Subsequently, the laminate was observed and evaluated by the following criteria.
(AA): No air bubbles are confirmed.
(F): One or more air bubbles are confirmed.

### Example 17

The pressure sensitive adhesive was applied to a silicone release PET film 1 with a thickness of 38 µm (NS-38+A available from Nakamoto Packs Co., Ltd., melting point: 262 °C, width: 340 mm) so that the thickness is 20 µm. Then, the pressure sensitive adhesive was dried to form a pressure sensitive adhesive layer (adhesive layer 1) to prepare a pressure sensitive adhesive sheet 1. The pressure sensitive adhesive was applied to a silicone release PET film 2 with a thickness of 38 µm (NS-38+A available from Nakamoto Packs Co., Ltd., melting point: 262 °C, width: 340 mm) so that the thickness is 20 µm. Then, the pressure sensitive adhesive was dried to form a pressure sensitive adhesive layer (adhesive layer 2) to prepare a pressure sensitive adhesive sheet 2.

Then, the pressure sensitive adhesive sheet 1 (width: 340 mm) was attached to the SiOₓ side of the moisture-resistant film B-1, and the pressure sensitive adhesive sheet 2 was attached to the other side of the moisture-resistant film B-1 (width: 340 mm) to obtain a laminate X.

Subsequently, both the ends in the width direction of the laminate X each were slit off 6 mm to form a laminate X' (width W_{X'}: 328 mm) .

Then, the release sheet of the laminate X' was peeled off, the weather-resistant film A-1 (width: 380 mm) and the film C-3 (width: 330 mm) were attached to the adhesive layer 1 and the adhesive layer 2, respectively. The laminate was cured at 40 °C for 4 days to obtain a protective sheet E-16 with the structure of weather-resistant film A-1/adhesive layer 1/moisture-resistant film B-1/adhesive layer 2/film C-3.

### Example 18

Except for setting the slit width of both ends of the laminate X to 10 mm, a protective sheet E-17 of Example 18 was obtained in the same way as Example 17. The Width W_{X'} of the laminate X' during the preparation process of Example 18 is 320 mm.

### Table 4

**Table 4**

| | Slit | Air bubbles |
|---|---|---|
| Example 17 | Slit | AA |
| Example 18 | Slit | AA |
| Comparative Example 1 | Not slit | F |

As shown in Table 4, the protective sheet of Examples 17 and 18 prevented air bubbles from being generated. For the protective sheet of Examples 17 and 18, the appearance after vacuum lamination was evaluated in the same manner as Example 1. From the evaluation, the laminates were rated as high as Example 1.

### Reference Signs List

1: weather-resistant film
21, 22: adhesive layer
3: film B
4: film C
51, 52: release sheet
6: slitter
10: protective sheet.
11: projecting part
20: encapsulating material
30: electronic device

## Claims

1. A protective sheet comprising: a weather-resistant film A, an adhesive layer 1, a film B, an adhesive layer 2, a film C in the stated order, the film C having a thickness of 60 µm or more, wherein the width W_{A} of the weather-resistant film, the width W_{B} of the film B, and the width W_{C} of the film C have a relationship of W_{A}>W_{C}>W_{B},
wherein the width of a film means the length in the lateral direction to the longitudinal direction of a winded off film when the protective sheet is provided in a roll shape and the length of the short side of a film when the protective sheet is provided in a sheet shape.

2. The protective sheet according to claim 1, wherein the ratio (W_{B}/W_{C}) of the width W_{B} to the width W_{C} is 0.65 or more and less than 1.0, and the difference (W_{C}-W_{B}) between the width W_{C} and the width W_{B} is 32 mm or less.

3. The protective sheet according to claim 1 or 2, wherein the ratio (W_{C}/W_{A}) of the width W_{C} to the width W_{A} is 0.70 or more and less than 1.0, and the difference (W_{A}-W_{C}) between the width W_{A} and the width W_{C} is 80 mm or less.

4. The protective sheet according to any one of claims 1 to 3, wherein the ratio of the thickness of the weather-resistant film A to the thickness of the film C (thickness of weather-resistant film A/thickness of film C) is 0.75 or less.

5. The protective sheet according to any one of claims 1 to 4, wherein the tensile elastic modulus at 23 °C of the film C is 2.0 GPa or more, as determined by a method of forming film C to tensile test dumbbell, the parallel part of which has a width of 10 mm and a length of 40 mm based on JIS K6734:2000 and then subjecting to tensile test in accordance with JIS K7161:1994, wherein the value is calculated from the slope of the straight-line part of the stress-strain curve as the tensile elastic modulus.

6. The protective sheet according to any one of claims 1 to 5, wherein the film B is a moisture-resistant film having a base material and an inorganic layer on at least one side of the base material and having a moisture vapor permeability of less than 0.1 g/m²/day, as determined in accordance with the conditions of JIS Z0222 "Method of permeability test for moisture proof packing case" and JIS Z0208 "Testing methods for determination of the water vapor transmission rate of moisture-proof packaging materials (dish method)", and
wherein the thickness of the film B is from 5 to 100 µm.

7. The protective sheet according to claim 6, wherein the inorganic layer side of the moisture-resistant film is laminated to the weather-resistant film A.

8. The protective sheet according to any one of claims 1 to 7, wherein the adhesive layer 1 and/or the adhesive layer 2 contains a pressure sensitive agent.

9. The protective sheet according to any one of claims 1 to 8, wherein the thermal shrinkage rate of the weather-resistant film A is 0.5% or more, as calculated by the expression (L₀-L₁)×100/L₀ in which L₀ represents the length of a sample before heating, L₁ represents the length of a sample after heating at 150 °C for 30 minutes with an oven.

10. The protective sheet according to any one of claims 1 to 9, wherein the protective sheet is used in a solar cell protective sheet.

11. An encapsulating material-integrated protective sheet formed by further laminating an encapsulating material layer D on the film C side of the protective sheet according to any one of claims 1 to 10.

12. The encapsulating material-integrated protective sheet according to claim 11, wherein the width W_{D} of the encapsulating material layer is less than the width W_{A} of the weather-resistant film and more than the width W_{C} of the film C.

13. A roll-shaped article formed by rolling up the protective sheet according to any one of claims 1 to 10 or the encapsulating material-integrated protective sheet according to claim 11 or 12.

14. A roll-shaped article with a cover sheet formed by at least partially covering a part at which the weather-resistant film A projects from the surface of the roll-shaped article according to claim 13 with a cover sheet having a deflection length of 70 mm or less and a load bearing dent of 0.1 or less, wherein
the deflection length is measured in a condition in which
(1) a sample with a width of 20 mm and a length of 120 mm is collected,
(2) the sample is placed on and protruded from a platform so that the protuberance from the platform has a length of 100 mm, and then a 5 kg weight is added on the part of the sample on the platform to fix the sample, and
(3) how much the end of the part of the sample being protruded from the platform hangs down from the platform is measured, and this measured length x (unit: mm) is determined as the deflection length,
the load bearing dent is measured in a condition in which
(1) A 100 mm square sample is collected,
(2) the sample is placed on a glass plate with a thickness of 20 mm, a 0.5 g steel ball with a diameter of 5 mm is added on the central part of the sample, and a 2 kg load is further added on the steel ball, and
(3) The dent "d" in the sample (unit: µm) is measured, and the ratio "d/t" of the dent "d" to the thickness "t" (unit: µm) of the sample is determined as the load bearing dent.

15. The roll-shaped article according to claim 14, wherein the conditions (a') and/or (b') are satisfied,
the condition (a') is deflection length of cover sheet / deflection length of weather-resistant film A ≤ 2, and
the condition (b') is load bearing dent of cover sheet / load bearing dent of weather-resistant film A ≤ 2.

16. A method of producing a protective sheet comprising the steps of:
(1) forming a laminate X having an adhesive layer 1 on one side of the film B and an adhesive layer 2 on the other side of the film B,
(2) slitting both the ends in the width direction of the laminate X to form a laminate X',
(3) attaching a weather-resistant film A having a width W_{A} being more than the width W_{X'} of the laminate X' to the adhesive layer 1 so that both the ends of the weather-resistant film A project from the respectively corresponding ends of the adhesive layer 1, and
(4) attaching a film C having a width W_{C} being more than the width W_{X'} of the laminate X' and less than the width W_{A} of the weather-resistant film A to an adhesive layer 2 so that both the ends of the film C project from the respectively corresponding ends of the adhesive layer 2,
wherein the width of a film means the length in the lateral direction to the longitudinal direction of a winded off film when the protective sheet is provided in a roll shape and the length of the short side of a film when the protective sheet is provided in a sheet shape.

17. The method of producing a protective sheet according to claim 16, wherein the laminate X having a release sheet 1 on the adhesive layer 1 and a release sheet 2 on the adhesive layer 2 is produced in the step (1), the release sheet 1 is peeled off after the step (2) before the step (3), and the release sheet 2 is peeled off after the step (2) before the step (4).

18. The method of producing a protective sheet according to claim 17, wherein the step (1) has the steps of:
(1-1) applying an adhesive layer 1 composition to the release sheet 1 and drying the adhesive layer 1 to form an adhesive layer 1,
(1-2) applying an adhesive layer 2 composition to the release sheet 2 and drying the adhesive layer 2 to form an adhesive layer 2, and
(1-3) attaching the film B between the adhesive layer 1 and the adhesive layer 2 to form a laminate X.

19. A solar cell module formed by using the protective sheet according to any one of claim 1 to 10 or the encapsulating material-integrated protective sheet according to claim 11 or 12.

## Patentansprüche

1. Schutzfolie, umfassend: einen wetterbeständigen Film A, eine Klebstoffschicht 1, einen Film B, eine Klebstoffschicht 2, einen Film C, in der angegebenen Reihenfolge, wobei der Film C eine Dicke von 60 µm oder mehr aufweist, wobei die Breite W_{A} des wetterbeständigen Films, die Breite W_{B} des Films B und die Breite W_{C} des Films C eine Beziehung von W_{A}>W_{C}>W_{B} aufweisen,
wobei die Breite eines Films die Länge in der Lateralrichtung zu der Längsrichtung eines abgewickelten Films bedeutet, wenn die Schutzfolie in einer Rollenform vorgesehen ist, und die Länge der kurzen Seite eines Films, wenn die Schutzfolie in einer Blattform vorgesehen ist.

2. Schutzfolie nach Anspruch 1, wobei das Verhältnis (W_{B}/W_{C}) der Breite W_{B} zu der Breite W_{C} 0,65 oder mehr und weniger als 1,0 beträgt, und die Differenz (W_{C}-W_{B}) zwischen der Breite W_{C} und der Breite W_{B} 32 mm oder weniger beträgt.

3. Schutzfolie nach Anspruch 1 oder 2, wobei das Verhältnis (W_{C}/W_{A}) der Breite W_{C} zu der Breite W_{A} 0,70 oder mehr und weniger als 1,0 beträgt, und die Differenz (W_{A}-W_{C}) zwischen der Breite W_{A} und der Breite W_{C} 80 mm oder weniger beträgt.

4. Schutzfolie nach irgendeinem der Ansprüche 1 bis 3, wobei das Verhältnis der Dicke des wetterbeständigen Films A zu der Dicke des Films C (Dicke wetterbeständiger Film A/Dicke Film C) 0,75 oder weniger beträgt.

5. Schutzfolie nach irgendeinem der Ansprüche 1 bis 4, wobei der Zug-Elastizitätsmodul bei 23°C des Films C 2,0 GPa oder mehr beträgt, wie bestimmt durch ein Verfahren des Bildens des Films C zu einem Zugtest-Probekörper, dessen paralleler Teil eine Breite von 10 mm und eine Länge von 40 mm aufweist, basierend auf JIS K6734:2000, und dann Unterziehen der Zugprüfung gemäß JIS K7161:1994, wobei der Wert berechnet wird aus der Steigung des geradlinigen Teils der Spannung-Dehnungs-Kurve als der Zug-Elastizitätsmodul.

6. Schutzfolie nach irgendeinem der Ansprüche 1 bis 5, wobei der Film B ein feuchtigkeitsbeständiger Film ist, aufweisend ein Grundmaterial und eine anorganische Schicht auf mindestens einer Seite des Grundmaterials und mit einer Feuchtigkeits-Dampf-Permeabilität von weniger als 0,1 g/m²/Tag, wie bestimmt gemäß den Bedingungen von JIS Z0222 "Method of permeability test for moisture proof packing case" und JIS Z0208 "Testing methods for determination of the water vapor transmission rate of moisture-proof packaging materials (dish method)", und wobei die Dicke des Films B 5 bis 100 µm beträgt.

7. Schutzfolie nach Anspruch 6, wobei die Seite der anorganischen Schicht des feuchtigkeitsbeständigen Films auf den wetterbeständigen Film A laminiert wird.

8. Schutzfolie nach irgendeinem der Ansprüche 1 bis 7, wobei die Klebstoffschicht 1 und/oder die Klebstoffschicht 2 einen druckreaktiven Klebstoff enthält.

9. Schutzfolie nach irgendeinem der Ansprüche 1 bis 8, wobei die thermische Schrumpfungsrate des wetterbeständigen Films A 0,5% oder mehr beträgt, wie berechnet durch den Ausdruck (L₀-L₁)x100/L₀, worin L₀ die Länge einer Probe vor dem Erhitzen bedeutet, L₁ die Länge einer Probe nach dem Erhitzen bei 150°C während 30 Minuten in einem Ofen bedeutet.

10. Schutzfolie nach irgendeinem der Ansprüche 1 bis 9, wobei die Schutzfolie in einer Solarzellen-Schutzfolie verwendet wird.

11. Einkapselungsmaterial-integrierte Schutzfolie, gebildet durch weiteres Laminieren einer Einkapselungsmaterialschicht D auf der Seite des Films C der Schutzfolie nach irgendeinem der Ansprüche 1 bis 10.

12. Einkapselungsmaterial-integrierte Schutzfolie nach Anspruch 11, wobei die Breite W_{D} der Einkapselungsmaterialschicht weniger als die Breite W_{A} des wetterbeständigen Films und mehr als die Breite W_{C} des Films C beträgt.

13. Rollenförmiger Gegenstand, gebildet durch Aufrollen der Schutzfolie nach irgendeinem der Ansprüche 1 bis 10 oder der Einkapselungsmaterial-integrierte Schutzfolie nach Anspruch 11 oder 12.

14. Rollenförmiger Gegenstand mit einer Deckfolie, gebildet durch mindestens teilweises Bedecken eines Teils, an welchem der wetterbeständige Film A aus der Oberfläche des rollenförmigen Gegenstands nach Anspruch 13 hervorsteht, mit einer Deckfolie, die eine Durchbiegungslänge von 70 mm oder weniger und eine lasttragende Einbuchtung von 0,1 oder weniger aufweist, wobei
die Durchbiegungslänge in einem Zustand gemessen wird, in welchem
(1) eine Probe mit einer Breite von 20 mm und einer Länge von 120 mm gesammelt wird,
(2) die Probe auf einer Plattform angeordnet wird und davon herausragt, sodass die Protuberanz von der Plattform eine Länge von 100 mm aufweist, und dann ein 5 kg Gewicht auf den Teil der Probe auf der Plattform gegeben wird, um die Probe zu fixieren, und
(3) gemessen wird, wieviel das Ende des Teils der Probe, welches von der Plattform herausragt, von der Plattform herunterhängt, und diese gemessene Länge x (Einheit: mm) bestimmt wird als die Durchbiegungslänge,
die lasttragende Einbuchtung gemessen wird in einem Zustand, in welchem
(1) eine 100 mm Quadratprobe gesammelt wird,
(2) die Probe auf einer Glasplatte mit einer Dicke von 20 mm angeordnet wird, eine 0,5 g Stahlkugel mit einem Durchmesser von 5 mm auf den Zentralteil der Probe gegeben wird, und eine 2 kg Last weiterhin auf die Stahlkugel gegeben wird, und
(3) die Einbuchtung "d" in der Probe (Einheit: µm) gemessen wird, und das Verhältnis "d/t" der Einbuchtung "d" zu der Dicke "t" (Einheit: µm) der Probe bestimmt wird als die lasttragende Einbuchtung.

15. Rollenförmiger Gegenstand nach Anspruch 14, wobei die Bedingungen (a') und/oder (b') erfüllt sind,
die Bedingung (a') ist Durchbiegungslänge der Deckfolie/Durchbiegungslänge des wetterbeständigen Films A ≤ 2, und
die Bedingung (b') ist lasttragende Einbuchtung der Deckfolie/lasttragende Einbuchtung des wetterbeständigen Films A ≤ 2.

16. Verfahren zur Herstellung einer Schutzfolie, umfassend die Schritte:
(1) Bilden eines Laminats X mit einer Klebstoffschicht 1 auf einer Seite des Films B und einer Klebstoffschicht 2 auf der anderen Seite des Films B,
(2) Aufschlitzen beider Enden in der Breitenrichtung des Laminats X zur Bildung eines Laminats X',
(3) Befestigen eines wetterbeständigen Films A mit einer Breite W_{A}, welche größer ist als die Breite W_{X'} des Laminats X', an der Klebstoffschicht 1, sodass beide der Enden des wetterbeständigen Films A von den jeweiligen korrespondierenden Enden der Klebstoffschicht 1 hervorstehen, und
(4) Befestigen eines Films C mit einer Breite W_{C}, welche größer ist als die Breite W_{X'} des Laminats X' und geringer als die Breite W_{A} des wetterbeständigen Films A, an einer Klebstoffschicht 2, sodass beide der Enden des Films C von den jeweiligen korrespondierenden Enden der Klebstoffschicht 2 hervorstehen,
wobei die Breite eines Films die Länge in der Lateralrichtung zu der Längsrichtung eines abgewickelten Films bedeutet, wenn die Schutzfolie in einer Rollenform vorgesehen ist, und die Länge der kurzen Seite eines Films, wenn die Schutzfolie in einer Blattform vorgesehen ist.

17. Verfahren zur Herstellung einer Schutzfolie nach Anspruch 16, wobei das Laminat X mit einer Trennfolie 1 auf der Klebstoffschicht 1 und einer Trennfolie 2 auf der Klebstoffschicht 2 in dem Schritt (1) hergestellt wird, die Trennfolie 1 nach dem Schritt 2 vor dem Schritt (3) abgezogen wird, und die Trennfolie 2 nach dem Schritt (2) vor dem Schritt (4) abgezogen wird.

18. Verfahren zur Herstellung einer Schutzfolie nach Anspruch 17, wobei der Schritt (1) die Schritte aufweist:
(1-1) Aufbringen einer Klebstoffschicht 1-Zusammensetzung auf die Trennfolie 1 und Trocknen der Klebstoffschicht 1 zur Bildung einer Klebstoffschicht 1,
(1-2) Aufbringen einer Klebstoffschicht 2-Zusammensetzung auf die Trennfolie 2 und Trocknen der Klebstoffschicht 2 zur Bildung einer Klebstoffschicht 2, und
(1-3) Befestigen des Films B zwischen der Klebstoffschicht 1 und der Klebstoffschicht 2 zur Bildung eines Laminats X.

19. Solarzellenmodul, gebildet durch Verwendung der Schutzfolie nach irgendeinem der Ansprüche 1 bis 10 oder der Einkapselungsmaterial-integrierte Schutzfolie nach Anspruch 11 oder 12.

## Revendications

1. Une feuille de protection comprenant: un film A résistant aux intempéries, une couche adhésive 1, un film B, une couche adhésive 2, un film C dans l'ordre indiqué, le film C ayant une épaisseur de 60 µm ou plus, dans laquelle la largeur W_{A} du film résistant aux intempéries, la largeur W_{B} du film B et la largeur W_{C} du film C ont une relation W_{A}>W_{C}>W_{B},
dans laquelle largeur d'un film signifie la longueur dans la direction latérale à la direction longitudinale d'un film déroulé quand la feuille de protection est pourvue sous forme de rouleau et la longueur du côté court d'un film quand la feuille de protection est pourvue en forme de feuille.

2. La feuille de protection selon la revendication 1, dans laquelle le rapport (W_{B}/W_{C}) de la largeur W_{B} à la largeur W_{C} est de 0,65 ou plus et inférieur à 1,0, et la différence (W_{C}-W_{B}) entre la largeur W_{C} et la largeur W_{B} est 32 mm ou moins.

3. La feuille de protection selon la revendication 1 ou 2, dans laquelle le rapport (W_{C}/W_{A}) de la largeur W_{C} à la largeur W_{A} est de 0,70 ou plus et inférieur à 1,0, et la différence (W_{A}-W_{C}) entre la largeur W_{A} et la largeur W_{C} est 80 mm ou moins.

4. La feuille de protection selon l'une quelconque des revendications 1 à 3, dans laquelle le rapport entre l'épaisseur A du film résistant aux intempéries et l'épaisseur du film C (épaisseur du film A résistant aux intempéries / épaisseur du film C) est de 0,75 ou moins.

5. La feuille de protection selon l'une quelconque des revendications 1 à 4, dans laquelle le module d'élasticité en traction à 23 °C du film C est de 2,0 GPa ou plus, tel que déterminé par un procédé de formation du film C en haltère d'essai de traction, la partie parallèle de laquelle a une épaisseur de 10 mm et une longueur de 40 mm basé sur JIS K6734:2000, et puis de soumettre à un essai de traction en accord avec JIS7161:1994, la valeur étant calculée à partir de l'inclinaison de la partie de ligne droite de la courbe contraint/déformation en tant que module élastique.

6. La feuille de protection selon l'une quelconque des revendications 1 à 5, dans laquelle le film B est un film résistant à l'humidité ayant un matériau de base et une couche inorganique sur au moins un côté du matériau de base et ayant une perméabilité à la vapeur d'eau de moins de 0,1 g / m² / jour, tel que déterminé en accord avec les conditions de JIS Z0222 « procédé de d'essai de perméabilité pour une caisse d'emballage résistant à résistant à l'humidité » et de JIS Z0208 « procédés d'essai pour la détermination du taux de transition de vapeur d'eau de matériaux d'emballage résistant à l'humidité (procédé de disque) », et
dans laquelle l'épaisseur du film B est de 5 à 100 µm.

7. La feuille de protection selon la revendication 6, dans laquelle le côté de la couche inorganique du film résistant à l'humidité est stratifié sur le film résistant aux intempéries A.

8. La feuille de protection selon l'une quelconque des revendications 1 à 7, dans laquelle la couche adhésive 1 et / ou la couche adhésive 2 contiennent un agent sensible à la pression.

9. La feuille de protection selon l'une quelconque des revendications 1 à 8, dans laquelle la vitesse de rétrécissement thermique du film A résistant aux intempéries est de 0,5% ou plus, tel que calculé par l'expression (L₀ - L₁) × 100/L₀ dans laquelle L₀ représente la longueur de l'échantillon avant le chauffage, L₁ représente la longueur de l'échantillon après le chauffage à 150 °C pendant 30 minutes avec un four.

10. La feuille de protection selon l'une quelconque des revendications 1 à 9, dans laquelle la feuille de protection est utilisée dans une feuille de protection de cellule solaire.

11. Une feuille de protection intégrée à un matériau d'encapsulation formée par stratification supplémentaire d'une couche de matériau d'encapsulation D sur le côté du film C de la feuille de protection selon l'une quelconque des revendications 1 à 10.

12. La feuille de protection intégrée à un matériau d'encapsulation selon la revendication 11, dans laquelle la largeur W_{D} de la couche de matériau d'encapsulation est inférieure à la largeur W_{A} du film résistant aux intempéries et supérieure à la largeur W_{C} du film C.

13. Un article en forme de rouleau formé en enroulant la feuille de protection selon l'une quelconque des revendications 1 à 10 ou la feuille de protection intégrée à un matériau d'encapsulation selon la revendication 11 ou 12.

14. Un article en forme de rouleau avec une feuille de couverture formée en recouvrant au moins partiellement une partie sur laquelle le film résistant aux intempéries A dépasse de la surface de l'article en forme de rouleau selon la revendication 13 avec une feuille de couverture ayant une longueur de déflexion de 70 mm ou moins et une entaille de support de charge de 0,1 ou moins, dans laquelle
la longueur de déflexion est mesurée dans une condition dans laquelle
(1) un échantillon d'une largeur de 20 mm et une longueur de 120 mm est recueilli,
(2) l'échantillon est placé sur et en saillie d'une plate-forme de sorte que la protubérance de la plate-forme a une longueur de 100 mm, et puis un poids de 5 kg est ajouté sur la partie de l'échantillon sur la plate-forme pour fixer l'échantillon, et
(3) combien la fin de la partie de l'échantillon en saillie de la plate-forme pend de la plate-forme est mesuré, et cette longueur x (unité: mm) mesurée est déterminée comme la longueur de déflexion,
l'entaille de support de charge est mesurée dans une condition dans laquelle
(1) un échantillon carré de 100 mm est recueilli,
(2) l'échantillon est placé sur une plaque de verre avec une épaisseur de 20 mm, une bille d'acier de 0,5 g d'un diamètre de 5 mm est ajoutée sur la partie centrale de l'échantillon, et une charge de 2 kg est en outre ajoutée sur la bille d'acier, et
(3) l'entaille « d » dans l'échantillon (unité: µm) est mesurée, et le rapport « d / t »de l'entaille « d » à l'épaisseur « t » (unité: µm) de l'échantillon est déterminé comme l'entaille portant la charge.

15. L'article en forme de rouleau selon la revendication 14, dans lequel les conditions (a') et / ou (b') sont satisfaites,
la condition (a') est la longueur de la déflexion de la feuille de couverture / longueur de déflection du film A résistant aux intempéries ≤ 2, et
la condition (b') est l'entaille portant la charge de la feuille de couverture / l'entaille portant la charge du film A résistant aux intempéries ≤ 2.

16. Un procédé de fabrication d'une feuille de protection comprenant les étapes consistant à:
(1) former un stratifié X ayant une couche adhésive 1 d'un côté du film B et une couche adhésive 2 de l'autre côté du film B,
(2) fendre les deux les extrémités dans la direction de la largeur du stratifié X pour former un stratifié X',
(3) attacher un film A résistant aux intempéries ayant une largeur W_{A} supérieure à la largeur W_{X'} du stratifié X' à la couche adhésive 1 de sorte que les deux extrémités du film A résistant aux intempéries est en saillie à partir des extrémités respectivement correspondantes de la couche adhésive 1, et
(4) attacher un film C ayant une largeur W_{C} supérieure à la largeur W_{X'} du stratifié X' et inférieure à la largeur W_{A} du film A résistant aux intempéries à une couche adhésive 2 de sorte que les deux extrémités du film C dépassent des extrémités respectivement correspondantes de la couche adhésive 2,
dans laquelle largeur d'un film signifie la longueur dans la direction latérale à la direction longitudinale d'un film déroulé quand la feuille de protection est pourvue sous forme de rouleau et la longueur du côté court d'un film quand la feuille de protection est pourvue en forme de feuille.

17. Le procédé de fabrication d'une feuille de protection selon la revendication 16, dans lequel le stratifié X ayant une feuille détachable 1 sur la couche adhésive 1 et une feuille détachable 2 sur la couche adhésive 2 est fabriqué dans l'étape (1), la feuille détachable 1 est décollée après l'étape (2) et avant l'étape (3), et la feuille détachable 2 est décollée après l'étape (2) et avant l'étape (4).

18. Le procédé de fabrication d'une feuille de protection selon la revendication 17, dans lequel l'étape (1) comprend les étapes consistant à:
(1-1) appliquer une composition de couche adhésive 1 sur la feuille détachable 1 et sécher la couche adhésive 1 pour former une couche adhésive 1,
(1-2) appliquer une composition de couche adhésive 2 sur la feuille détachable 2 et sécher la couche adhésive 2 pour former une couche adhésive 2, et
(1-3) fixer le film B entre la couche adhésive 1 et la couche adhésive 2 pour former un stratifié X.

19. Un module de cellule solaire formé en utilisant la feuille de protection selon l'une quelconque des revendications 1 à 10 ou la feuille de protection intégrée à un matériau d'encapsulation selon la revendication 11 ou 12.
